# EUROPEAN PATENT APPLICATION

(11) **EP 4 773 778 A1**
(43) Date of publication of application: **08.07.2026**
(21) Application number: 24882747.9
(22) Date of filing: 18.10.2024
(51) Int. Cl.: H10K 59/131, H10K 77/10, G09F 9/30, G06F 1/16, H10K 59/35, H10K 59/121, G09G 3/3233, H10K 59/124, H10K 59/80

(54) **DISPLAY DEVICE**

(30) Priority: 24.10.2023 KR 20230143249
(71) Applicant: Samsung Display Co., Ltd., Yongin-si, Gyeonggi-do 17113 (KR)
(72) Inventor: LEE, Hyun Sup, Yongin-si Gyeonggi-do 17113 (KR); LEE, Jae Been, Yongin-si Gyeonggi-do 17113 (KR)
(74) Representative: Walaski, Jan Filip
(86) International application number: PCT/KR2024/015915
(87) International publication number: WO 2025/089720

(57) **Abstract**

A display apparatus includes a substrate including a plurality of island portions apart from each other, a bridge portion connecting the plurality of island portions to each other, and an opening portion arranged between the plurality of island portions, light-emitting elements arranged in each of the plurality of island portions, and protruding electrodes arranged between the substrate and the light-emitting elements and connected to the light-emitting elements, wherein the protruding electrodes include a first protruding electrode and a second protruding electrode, wherein a thickness of the first protruding electrode is different from a thickness of the second protruding electrode.

## Description

### Technical Field

One or more embodiments relate to a display apparatus, for example, a flexible display apparatus.

### Background Art

As display apparatuses visually displaying electrical signals have developed, various display apparatuses having excellent characteristics, such as thinness, light weight, and low power consumption, have been introduced. For example, flexible display apparatuses that may be folded or rolled into a roll shape have been introduced. Recently, research on and development of display apparatuses with various structures, such as stretchable display apparatuses that may change into various shapes, have been actively conducted.

### Disclosure of Invention

### Technical Problem

One or more embodiments include a display apparatus, for example, a flexible display apparatus.

### Solution to Problem

According to one or more embodiments, a display apparatus includes a substrate including a plurality of island portions apart from each other, a bridge portion connecting the plurality of island portions to each other, and an opening portion arranged between the plurality of island portions, light-emitting elements arranged in each of the plurality of island portions, and protruding electrodes arranged between the substrate and the light-emitting elements and connected to the light-emitting elements, wherein the protruding electrodes include a first protruding electrode and a second protruding electrode, wherein a thickness of the first protruding electrode is different from a thickness of the second protruding electrode.

The protruding electrodes may be apart from each other.

The light-emitting elements may include a first light-emitting element and a second light-emitting element configured to emit lights of different colors from each other, wherein the first light-emitting element may be arranged on the first protruding electrode, and the second light-emitting element may be arranged on the second protruding electrode.

The display apparatus may further include a circuit layer arranged between the substrate and the protruding electrodes and including a pixel driving circuit portion and a bottom insulating layer covering the pixel driving circuit portion, a common electrode pad and electrode pads arranged on the bottom insulating layer, a top insulating layer at least partially covering the light-emitting elements and including a contact hole exposing the common electrode pad, and a common electrode arranged on the top insulating layer, wherein each of the light-emitting elements may include a first electrode arranged at the bottom and a second electrode arranged at the top, wherein second electrodes of the light-emitting elements may be electrically connected to the common electrode pad through the contact hole.

Each of the protruding electrodes may include a protrusion including an organic insulating material and including a via hole in the middle, and a bonding pad arranged inside the via hole and on the protrusion and including a conductive material.

The thickness of the second protruding electrode may be greater than the thickness of the first protruding electrode, wherein the protrusion of the second protruding electrode may cover at least a portion of the protrusion of the first protruding electrode.

The protrusion of the protruding electrodes may protrude from a lower portion of the light-emitting element, and the bonding pad may be arranged under the protrusion.

The light-emitting elements may include a first light-emitting element, a second light-emitting element, and a third light-emitting element emitting light of different colors from one another, wherein a size of the first light-emitting element may be greater than a size of each of the second light-emitting element and the third light-emitting element.

The protruding electrodes may further include a third protruding electrode, wherein the first light-emitting element, the second light-emitting element, and the third light-emitting element may be connected to the first protruding electrode, the second protruding electrode, and the third protruding electrode, respectively, wherein the thickness of the first protruding electrode may be greater than the thickness of the second protruding electrode and a thickness of the third protruding electrode.

The thickness of the second protruding electrode may be the same as the thickness of the third protruding electrode.

According to one or more embodiments, a display apparatus includes a substrate including a plurality of island portions apart from each other, a bridge portion connecting the plurality of island portions to each other, and an opening portion arranged between the plurality of island portions, a circuit layer including a pixel driving circuit portion arranged on the plurality of island portions and a bottom insulating layer covering the pixel driving circuit portion, a first electrode pad, a second electrode pad, and a third electrode pad arranged on the bottom insulating layer, a first protruding electrode, a second protruding electrode, and a third protruding electrode arranged on the bottom insulating layer and corresponding to the first electrode pad, the second electrode pad, and the third electrode pad, respectively, and a first light-emitting element, a second light-emitting element, and a third light-emitting element connected to the first protruding electrode, the second protruding electrode, and the third protruding electrode, respectively, wherein thicknesses of the first protruding electrode, the second protruding electrode, and the third protruding electrode are different from one another.

The first protruding electrode, the second protruding electrode, and the third protruding electrode may be apart from one another.

The first light-emitting element, the second light-emitting element, and the third light-emitting element may be configured to emit lights of different colors from one another.

The display apparatus may further include a common electrode pad arranged on the bottom insulating layer at the island portion, a top insulating layer at least partially covering the first light-emitting element, the second light-emitting element, and the third light-emitting element, and including a contact hole exposing the common electrode pad, and a common electrode arranged on the top insulating layer, wherein the common electrode may be connected to the common electrode pad through the contact hole.

Each of the first protruding electrode, the second protruding electrode, and the third protruding electrode may include a protrusion including an organic insulating material and including a via hole in the middle, and a bonding pad arranged inside the via hole and on the protrusion and including a conductive material.

Protrusions of the first protruding electrode, the second protruding electrode, and the third protruding electrode may directly cover the first electrode pad, the second electrode pad, and the third electrode pad, respectively.

The thickness of the second protruding electrode may be greater than the thickness of the first protruding electrode, wherein the protrusion of the second protruding electrode may cover at least a portion of the protrusion of the first protruding electrode.

A size of the first light-emitting element may be greater than a size of each of the second light-emitting element and the third light-emitting element.

The thickness of the first protruding electrode may be greater than the thickness of the second protruding electrode and the thickness of the third protruding electrode.

The thickness of the second protruding electrode may be the same as the thickness of the third protruding electrode.

### Advantageous Effects of Invention

According to one or more embodiments, damage due to the concentration of stress may be prevented, and a display apparatus stretchable in various directions may be provided. However, such an effect is an example, and one or more embodiments are not limited by the above effect.

### Brief Description of Drawings

FIG. 1 is a schematic perspective view of a display apparatus according to an embodiment.
FIGS. 2A and 2B are perspective views showing the display apparatus of FIG. 1 stretched in a first direction.
FIG. 2C is a perspective view showing the display apparatus of FIG. 1 stretched in a second direction.
FIG. 2D is a perspective view showing the display apparatus of FIG. 1 stretched in the first direction and the second direction.
FIG. 2E is a perspective view showing the display apparatus of FIG. 1 stretched in a third direction.
FIG. 3 is a schematic plan view of a display apparatus according to an embodiment.
FIG. 4A is an enlarged plan view of a region IV of FIG. 3 as part of a display apparatus according to an embodiment.
FIG. 4B is an enlarged plan view of the region IV of FIG. 3 as part of a display apparatus according to an embodiment.
FIG. 4C is an enlarged plan view of the region IV of FIG. 3 as part of a display apparatus according to an embodiment.
FIG. 5 is a schematic cross-sectional view of a first island portion and a first bridge portion arranged in a display area of a display apparatus according to an embodiment.
FIGS. 6A to 6C are each an equivalent circuit diagram of a sub-pixel of a display apparatus according to an embodiment.
FIGS. 7A to 7C are each a schematic cross-sectional view of a light-emitting element of a display apparatus according to an embodiment.
FIG. 8 is a plan view of a portion of a display apparatus according to an embodiment.
FIG. 9 is a schematic cross-sectional view of a portion of the display apparatus of FIG. 8, taken along a line I-I' of FIG. 8.
FIGS. 10A to 10F are schematic cross-sectional views sequentially showing a method of manufacturing a display apparatus, according to an embodiment.
FIG. 11 is a schematic cross-sectional view of a display apparatus according to an embodiment.
FIG. 12 is a schematic cross-sectional view of a display apparatus according to an embodiment.
FIG. 13 is a plan view of a portion of a display apparatus according to an embodiment.
FIG. 14 is a schematic cross-sectional view of a portion of the display apparatus of FIG. 13, taken along a line II-II' of FIG. 13.
FIGS. 15A to 15G are each a perspective view schematically showing embodiments of an electronic device including a display apparatus according to an embodiment.

### Best Mode for Carrying out the Invention

According to one or more embodiments, a display apparatus includes a substrate including a plurality of island portions apart from each other, a bridge portion connecting the plurality of island portions to each other, and an opening portion arranged between the plurality of island portions, light-emitting elements arranged in each of the plurality of island portions, and protruding electrodes arranged between the substrate and the light-emitting elements and connected to the light-emitting elements, wherein the protruding electrodes include a first protruding electrode and a second protruding electrode, wherein a thickness of the first protruding electrode is different from a thickness of the second protruding electrode.

The protruding electrodes may be apart from each other.

The light-emitting elements may include a first light-emitting element and a second light-emitting element configured to emit lights of different colors from each other, wherein the first light-emitting element may be arranged on the first protruding electrode, and the second light-emitting element may be arranged on the second protruding electrode.

The display apparatus may further include a circuit layer arranged between the substrate and the protruding electrodes and including a pixel driving circuit portion and a bottom insulating layer covering the pixel driving circuit portion, a common electrode pad and electrode pads arranged on the bottom insulating layer, a top insulating layer at least partially covering the light-emitting elements and including a contact hole exposing the common electrode pad, and a common electrode arranged on the top insulating layer, wherein each of the light-emitting elements may include a first electrode arranged at the bottom and a second electrode arranged at the top, wherein second electrodes of the light-emitting elements may be electrically connected to the common electrode pad through the contact hole.

Each of the protruding electrodes may include a protrusion including an organic insulating material and including a via hole in the middle, and a bonding pad arranged inside the via hole and on the protrusion and including a conductive material.

The thickness of the second protruding electrode may be greater than the thickness of the first protruding electrode, wherein the protrusion of the second protruding electrode may cover at least a portion of the protrusion of the first protruding electrode.

The protrusion of the protruding electrodes may protrude from a lower portion of the light-emitting element, and the bonding pad may be arranged under the protrusion.

The light-emitting elements may include a first light-emitting element, a second light-emitting element, and a third light-emitting element emitting light of different colors from one another, wherein a size of the first light-emitting element may be greater than a size of each of the second light-emitting element and the third light-emitting element.

The protruding electrodes may further include a third protruding electrode, wherein the first light-emitting element, the second light-emitting element, and the third light-emitting element may be connected to the first protruding electrode, the second protruding electrode, and the third protruding electrode, respectively, wherein the thickness of the first protruding electrode may be greater than the thickness of the second protruding electrode and a thickness of the third protruding electrode.

The thickness of the second protruding electrode may be the same as the thickness of the third protruding electrode.

According to one or more embodiments, a display apparatus includes a substrate including a plurality of island portions apart from each other, a bridge portion connecting the plurality of island portions to each other, and an opening portion arranged between the plurality of island portions, a circuit layer including a pixel driving circuit portion arranged on the plurality of island portions and a bottom insulating layer covering the pixel driving circuit portion, a first electrode pad, a second electrode pad, and a third electrode pad arranged on the bottom insulating layer, a first protruding electrode, a second protruding electrode, and a third protruding electrode arranged on the bottom insulating layer and corresponding to the first electrode pad, the second electrode pad, and the third electrode pad, respectively, and a first light-emitting element, a second light-emitting element, and a third light-emitting element connected to the first protruding electrode, the second protruding electrode, and the third protruding electrode, respectively, wherein thicknesses of the first protruding electrode, the second protruding electrode, and the third protruding electrode are different from one another.

The first protruding electrode, the second protruding electrode, and the third protruding electrode may be apart from one another.

The first light-emitting element, the second light-emitting element, and the third light-emitting element may be configured to emit lights of different colors from one another.

The display apparatus may further include a common electrode pad arranged on the bottom insulating layer at the island portion, a top insulating layer at least partially covering the first light-emitting element, the second light-emitting element, and the third light-emitting element, and including a contact hole exposing the common electrode pad, and a common electrode arranged on the top insulating layer, wherein the common electrode may be connected to the common electrode pad through the contact hole.

Each of the first protruding electrode, the second protruding electrode, and the third protruding electrode may include a protrusion including an organic insulating material and including a via hole in the middle, and a bonding pad arranged inside the via hole and on the protrusion and including a conductive material.

Protrusions of the first protruding electrode, the second protruding electrode, and the third protruding electrode may directly cover the first electrode pad, the second electrode pad, and the third electrode pad, respectively.

The thickness of the second protruding electrode may be greater than the thickness of the first protruding electrode, wherein the protrusion of the second protruding electrode may cover at least a portion of the protrusion of the first protruding electrode.

A size of the first light-emitting element may be greater than a size of each of the second light-emitting element and the third light-emitting element.

The thickness of the first protruding electrode may be greater than the thickness of the second protruding electrode and the thickness of the third protruding electrode.

The thickness of the second protruding electrode may be the same as the thickness of the third protruding electrode.

### Mode for the Invention

As the present description allows for various changes and numerous embodiments, certain embodiments will be illustrated in the drawings and described in the written description. Effects and features of one or more embodiments and methods of accomplishing the same will become apparent from the following detailed description of the one or more embodiments, taken in conjunction with the accompanying drawings. However, the present embodiments may have different forms and should not be construed as being limited to the descriptions set forth herein.

One or more embodiments will be described below in more detail with reference to the accompanying drawings. Those elements that are the same or are in correspondence with each other are rendered the same reference numeral regardless of the figure number, and redundant descriptions thereof are omitted.

While such terms as "first" and "second" may be used to describe various elements, such elements must not be limited to the above terms. The above terms are used only to distinguish one element from another.

The singular forms "a," "an," and "the" as used herein are intended to include the plural forms as well unless the context clearly indicates otherwise.

It will be understood that the terms "include," "comprise," and "have" as used herein specify the presence of stated features or elements but do not preclude the addition of one or more other features or elements.

It will be further understood that, when a layer, region, or element is referred to as being on another layer, region, or element, it may be directly or indirectly on the other layer, region, or element. That is, for example, intervening layers, regions, or elements may be present.

Sizes of elements in the drawings may be exaggerated or reduced for convenience of explanation. For example, since sizes and thicknesses of elements in the drawings are arbitrarily illustrated for convenience of explanation, the following embodiments are not limited thereto.

When an embodiment may be implemented differently, a certain process order may be performed differently from the described order. For example, two consecutively described processes may be performed substantially at the same time or performed in an order opposite to the described order.

As used herein, the expression "A and/or B" refers to A, B, or A and B. In addition, the expression "at least one of A or B" refers to A, B, or A and B.

It will be further understood that, when layers, regions, or elements are referred to as being connected to each other, they may be directly connected to each other and/or may be indirectly connected to each other with intervening layers, regions, or elements therebetween. For example, when layers, regions, or elements are referred to as being electrically connected to each other, they may be directly electrically connected to each other and/or may be indirectly electrically connected to each other with intervening layers, regions, or elements therebetween.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

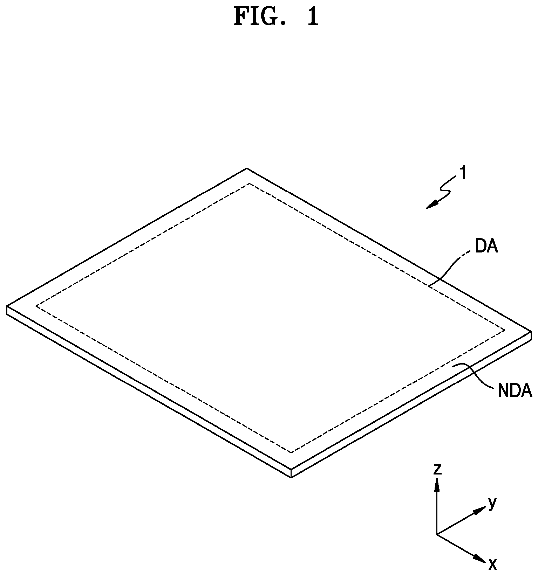

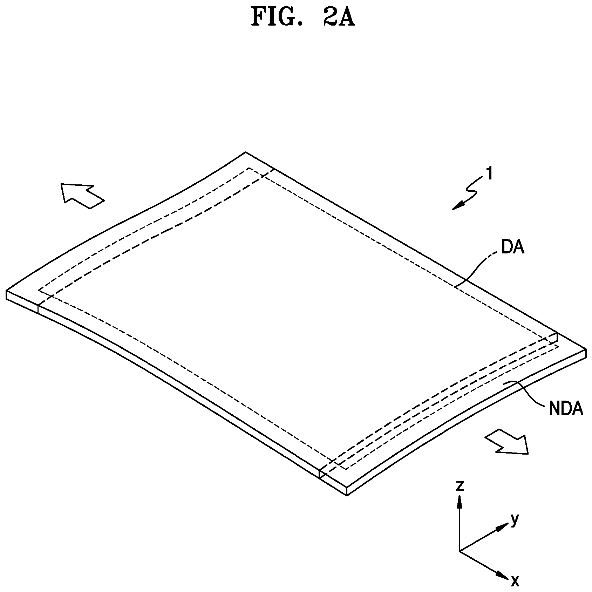

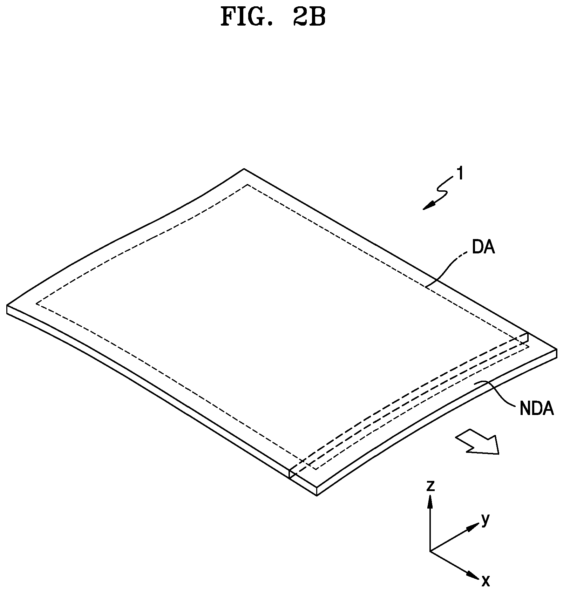

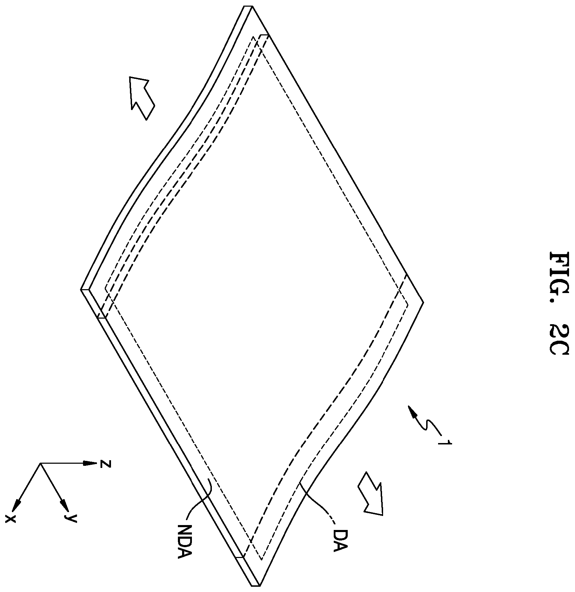

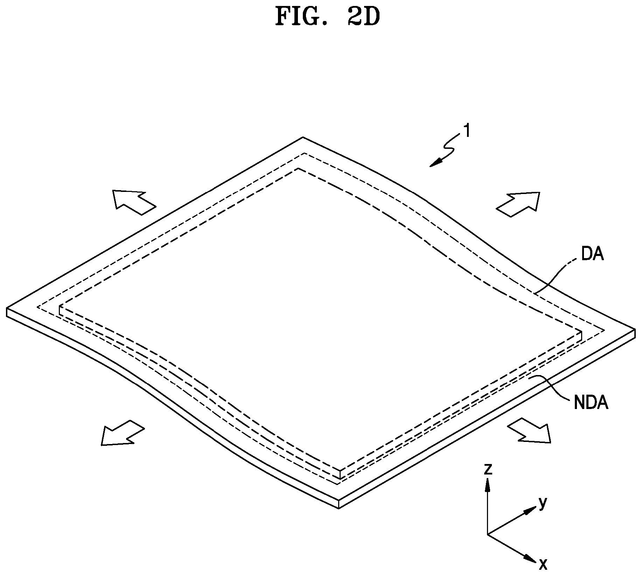

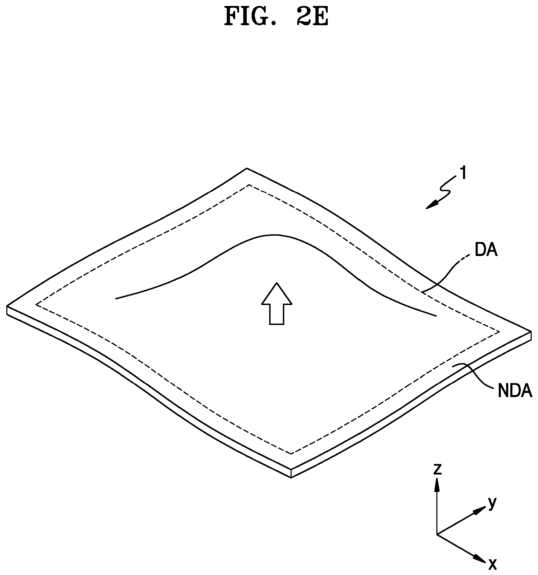

FIG. 1 is a schematic perspective view of a display apparatus 1 according to an embodiment. FIGS. 2A and 2B are perspective views showing the display apparatus 1 of FIG. 1 stretched in a first direction. FIG. 2C is a perspective view showing the display apparatus 1 of FIG. 1 stretched in a second direction. FIG. 2D is a perspective view showing the display apparatus 1 of FIG. 1 stretched in the first direction and the second direction. FIG. 2E is a perspective view showing the display apparatus 1 of FIG. 1 stretched in a third direction.

Referring to FIG. 1, the display apparatus 1 may include a display area DA and a non-display area NDA. The display area DA may include a plurality of pixels. The display apparatus 1 may provide a certain image by using light emitted from the plurality of pixels. The non-display area NDA may be arranged outside the display area DA. The non-display area NDA is an area where pixels are not arranged, and may entirely surround the display area DA.

The display apparatus 1 may stretch or shrink in various directions. The display apparatus 1 may be stretched in a first direction (e.g., a direction x and/or a direction -x) by an external object or an external force applied by a user. In an embodiment, as shown in FIGS. 2A and 2B, the display area DA and/or the non-display area NDA of the display apparatus 1 may be stretched in the first direction (e.g., the direction x and/or the direction -x). For example, the display area DA and/or the non-display area NDA of the display apparatus 1 may be stretched in the direction x and the direction -x as shown in FIG. 2A or may be stretched in the direction x with one side of the display apparatus 1 fixed as shown in FIG. 2B.

The display apparatus 1 may be stretched in a second direction (e.g., a direction y and/or a direction -y) by an external object or an external force applied by a user. In an embodiment, as shown in FIG. 2C, the display area DA and/or the non-display area NDA of the display apparatus 1 may be stretched in the direction y and the direction -y. In another embodiment, the display area DA and/or the non-display area NDA of the display apparatus 1 may be stretched in the direction y or the direction -y with one side of the display apparatus 1 fixed.

The display apparatus 1 may be stretched in a plurality of directions, for example, the first direction (e.g., the direction x and/or the direction -x) and the second direction (e.g., the direction y and/or the direction -y), by an external object or an external force applied by part of a human body. As shown in FIG. 2D, the display area DA and/or the non-display area NDA of the display apparatus 1 may be stretched in the direction ±x and the direction ±y.

The display apparatus 1 may be stretched in a third direction (e.g., a direction z or a direction -z) by an external object or an external force applied by part of a human body. As an embodiment, FIG. 2E shows a portion of the display apparatus 1, for example, a partial region of the display area DA, protruding in the direction z. In another embodiment, a portion of the display apparatus 1, for example, a partial region of the display area DA, may protrude in the direction -z (or be depressed in the direction z).

Although FIGS. 2A to 2E show the display apparatus 1 stretched in the first direction, the second direction and/or the third direction, one or more embodiments are not limited thereto. In another embodiment, the display apparatus 1 may be modified into various atypical shapes such as being bent or twisted along two or more axes.

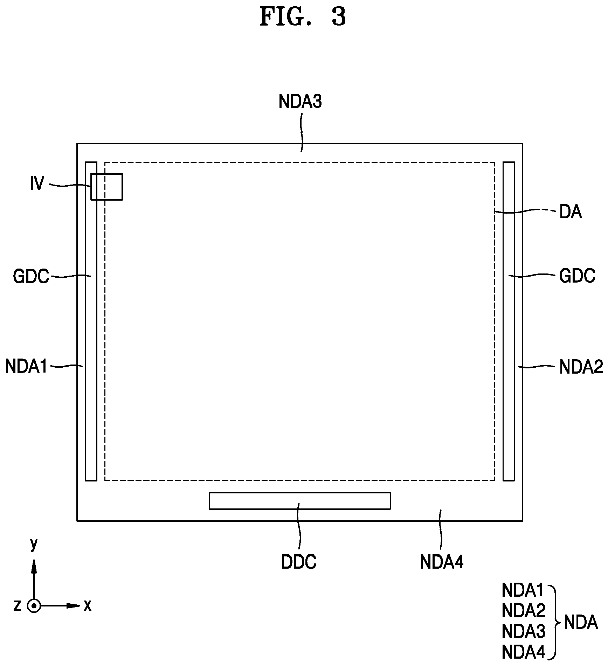

FIG. 3 is a schematic plan view of the display apparatus 1 according to an embodiment.

A plurality of pixels may be arranged in the display area DA of the display apparatus 1. Each pixel may include sub-pixels emitting light of different colors from one another. A light-emitting element corresponding to each sub-pixel may be arranged in the display area DA. A circuit for providing an electrical signal to light-emitting elements arranged in the display area DA and transistors electrically connected to the light-emitting elements may be in the non-display area NDA arranged around the display area DA. A gate driving circuit GDC may be arranged in each of a first non-display area NDA1 and a second non-display area NDA2 arranged on both sides of the display area DA. The gate driving circuit GDC may include drivers for providing an electrical signal to a gate electrode of each of the transistors electrically connected to the light-emitting elements. Although FIG. 3 shows the gate driving circuit GDC arranged in each of the first non-display area NDA1 and the second non-display area NDA2, one or more embodiments are not limited thereto. In another embodiment, the gate driving circuit GDC may be arranged in any one of the first non-display area NDA1 and the second non-display area NDA2.

A data driving circuit DDC may be arranged in a third non-display area NDA3 and/or a fourth non-display area NDA4 connecting the first non-display area NDA1 and the second non-display area NDA2 to each other. As an embodiment, FIG. 3 shows the data driving circuit DDC arranged in the fourth non-display area NDA4. In another embodiment, the data driving circuit DDC may be arranged in each of the third non-display area NDA3 and the fourth non-display area NDA4.

Although FIG. 3 shows the data driving circuit DDC arranged in the fourth non-display area NDA4 of the display apparatus 1, one or more embodiments are not limited thereto. In another embodiment, the display apparatus 1 may further include a flexible circuit board (not shown) electrically connected through a terminal portion (not shown) arranged in the fourth non-display area NDA4, and the data driving circuit DDC may be disposed on the flexible circuit board described above.

In some embodiments, an elongation rate of the non-display area NDA may be equal to or less than an elongation rate of the display area DA. In an embodiment, an elongation rate of the non-display area NDA may vary from region to region. For example, the first non-display area NDA1, the second non-display area NDA2, and the third non-display area NDA3 may have substantially the same elongation rate, but an elongation rate of the fourth non-display area NDA4 may be less than the elongation rate of each of the first non-display area NDA1, the second non-display area NDA2, and the third non-display area NDA3.

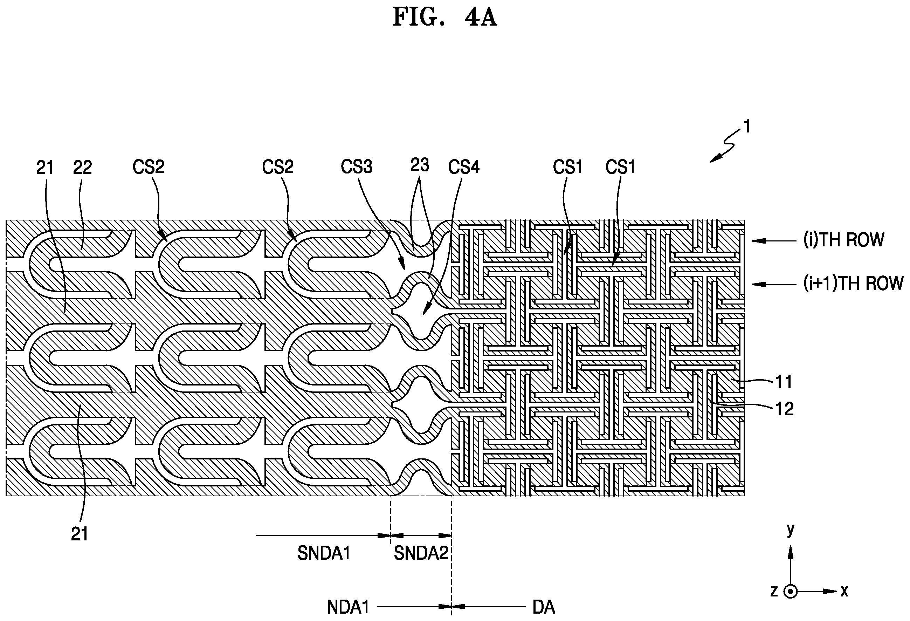

FIG. 4A is an enlarged plan view of a region IV of FIG. 3 as part of the display apparatus 1 according to an embodiment.

Referring to FIG. 4A, the display apparatus 1 may include first island portions 11 apart from each other in a first direction (e.g., the direction x or the direction -x) and a second direction (e.g., the direction y or the direction -y) in the display area DA and first bridge portions 12 connecting adjacent first island portions 11 to each other.

Each first island portion 11 may be connected to a plurality of first bridge portions 12. For example, each first island portion 11 may be connected to four first bridge portions 12. Two first bridge portions 12 may be arranged on both sides of the first island portion 11 in the first direction (e.g., the direction x or the direction -x), and the other two first bridge portions 12 may be arranged on both sides of the first island portion 11 in the second direction (e.g., the direction y or the direction -y). In an embodiment, the four first bridge portions 12 may be connected to four sides of the first island portion 11, respectively. Each of the four first bridge portions 12 may be adjacent to each corner of the first island portion 11.

The first bridge portions 12 may be apart from each other due to a first opening portion CS1 between the first bridge portions 12. In an embodiment, the first opening portion CS1 having approximately an H shape and the first opening portion CS1 having approximately an I shape obtained by rotating the above-described H shape by 90 degrees may repeatedly alternate with each other in each of the first direction (e.g., the direction x or the direction -x) and the second direction (e.g., the direction y or the direction -y). Both ends of each first bridge portion 12 may be connected to adjacent first island portions 11, respectively, and one side of each first bridge portion 12 may be apart from one side of the adjacent first island portion 11 and/or one side of another first bridge portion 12 due to the first opening portion CS1.

The display apparatus 1 may include second island portions 21 apart from each other in a non-display area, for example, the first non-display area NDA1 shown in FIG. 4A, and second bridge portions 22 connecting adjacent second island portions 21 to each other.

Each second island portion 21 may extend in the first direction (e.g., the direction x or the direction -x). The second island portions 21 may be apart from each other in the second direction (e.g., the direction y or the direction -y) crossing the first direction (e.g., the direction x or the direction -x). Each second island portion 21 may include drivers of the gate driving circuit GDC (of FIG. 3) described with reference to FIG. 3.

A second bridge portion 22 may have a serpentine shape. A length of the second bridge portion 22 may be greater than a shortest distance between second island portions 21 adjacent to each other in the second direction (e.g., the direction y or the direction -y). In an embodiment, the second bridge portion 22 may have approximately an omega (Ω) shape that is convex toward the first direction (e.g., the direction x or the direction -x). The second bridge portions 22 may be arranged between adjacent second island portions 21 and may be apart from each other.

The second bridge portions 22 between the adjacent second island portions 21 may be apart from each other due to a second opening portion CS2. Between the adjacent second island portions 21, second opening portions CS2 and the second bridge portions 22 may alternate with each other in the first direction (e.g., the direction x or the direction -x). Shapes of the second opening portions CS2 may be the same as each other. Both ends of each second bridge portion 22 may be connected to adjacent second island portions 21, and one side of each second bridge portion 22 may be apart from a side of the adjacent second island portion 21 and/or one side of another second bridge portion 22 due to the second opening portion CS2.

Any one second island portion 21 arranged in the first non-display area NDA1 may correspond to first island portions 11 in a plurality of rows arranged in the display area DA. For example, any one second island portion 21 arranged in the first non-display area NDA1 may correspond to first island portions 11 arranged in a (i)th row and first island portions 11 arranged in a (i+1)th row in the display area DA (where i is a positive number greater than 0). Although FIG. 4A shows one second island portion 21 corresponding to two rows of first island portions 11, one or more embodiments are not limited thereto. In another embodiment, any one second island portion 21 arranged in the first non-display area NDA1 may correspond to n rows of first island portions 11 arranged in the display area DA (where n is a positive number equal to or greater than 3).

The non-display area, for example, the first non-display area NDA1, may include a first sub-non-display area SNDA1 in which the second island portions 21 and the second bridge portions 22 described above are arranged, and a second sub-non-display area SNDA2 between the first sub-non-display area SNDA1 and the display area DA. Third bridge portions 23 for connecting the display area DA and the first sub-non-display area SNDA1 to each other may be arranged in the second sub-non-display area SNDA2. One end of a third bridge portion 23 may be connected to the second island portion 21 and/or the second bridge portion 22, and the other end of the third bridge portion 23 may be connected to the first island portion 11 and/or the first bridge portion 12.

The third bridge portion 23 may have a serpentine shape. In an embodiment, a shape of the third bridge portion 23 may be different from a shape of each of the first bridge portion 12 and the second bridge portion 22. In an embodiment, as shown in FIG. 4A, the third bridge portion 23 may have approximately an omega (Ω) shape that is convex toward the second direction (e.g., the direction y or the direction -y). Among adjacent third bridge portions 23 arranged in the second direction (e.g., the direction y or the direction -y), one may be convex in the direction y and the other may be convex in the direction -y to have a symmetrical structure. A third opening portion CS3 and a fourth opening portion CS4 of different shapes may be repeated between the third bridge portions 23. A width of the third bridge portion 23 may be different from a width of the first bridge portion 12 and a width of the second bridge portion 22. In an embodiment, the width of the third bridge portion 23 may be greater than the width of the first bridge portion 12 and less than the width of the second bridge portion 22.

FIG. 4A shows the second island portion 21 and the second bridge portion 22 of the non-display area, for example, the first non-display area NDA1, having different shapes than the first island portion 11 and the first bridge portion 12 of the display area DA, respectively. In another embodiment, the second island portion 21 and the second bridge portion 22 of the non-display area may have the same shape as those of the first island portion 11 and the first bridge portion 12 of the display area DA, respectively.

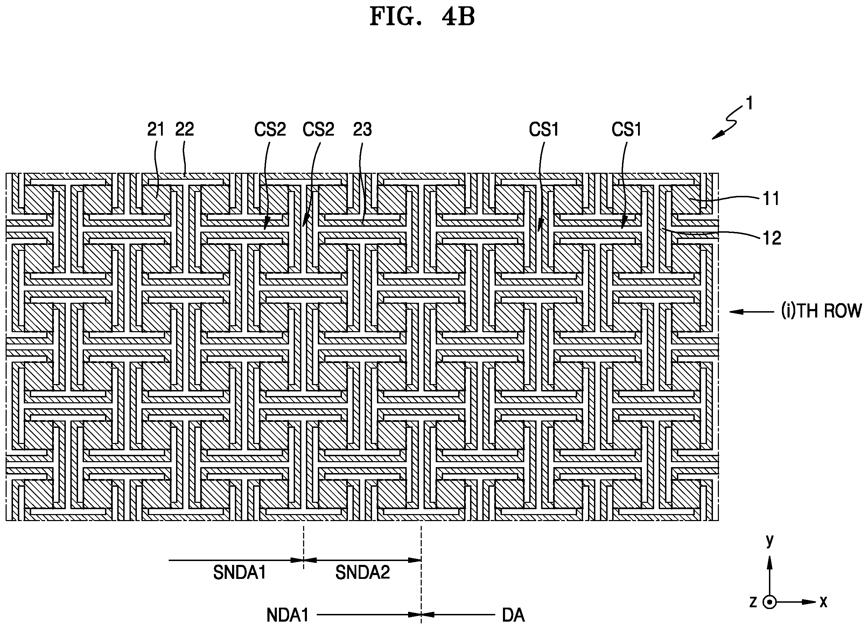

FIG. 4B is an enlarged plan view of a region IV of FIG. 3 as part of the display apparatus 1 according to an embodiment.

Referring to FIG. 4B, the display apparatus 1 includes the first island portions 11 apart from each other in the display area DA and the first bridge portions 12 connecting the first island portions 11 apart from each other due to the first opening portion CS1 but adjacent to each other. A structure of the display area DA of FIG. 4B may be the same as a structure of the display area DA described above with reference to FIG. 4A.

The display apparatus 1 may include second island portions 21 and second bridge portions 22 arranged in a non-display area, for example, the first non-display area NDA1. In an embodiment, the second island portions 21 and the second bridge portions 22 may have substantially the same shape as those of the first island portions 11 and the first bridge portions 12, respectively.

The second island portions 21 may be apart from each other in a first direction (e.g., the direction x or the direction -x) and a second direction (e.g., the direction y or the direction -y) in the non-display area, for example, the first non-display area NDA1. Each of the second bridge portions 22 may connect adjacent second island portions 21 to each other. The second bridge portions 22 may be apart from each other due to a second opening portion CS2 between the second bridge portions 22.

The second opening portion CS2 may have substantially the same shape as that of the first opening portion CS1. For example, the second opening portion CS2 having approximately an H shape and the second opening portion CS2 having approximately an I shape may repeatedly alternate with each other in the non-display area, for example, the first non-display area NDA1. Both ends of each second bridge portion 22 may be connected to adjacent second island portions 21, respectively, and one side of each second bridge portion 22 may be apart from one side of the adjacent second island portion 21 and/or one side of another second bridge portion 22 due to the second opening portion CS2.

Each second island portion 21 may be connected to four second bridge portions 22. Each second island portion 21 may include drivers of the gate driving circuit GDC (of FIG. 3) described with reference to FIG. 3.

Second island portions 21 in any one row arranged in the first non-display area NDA1 may correspond to first island portions 11 in any one row arranged in the display area DA. For example, second island portions 21 arranged in a (i)th row in the first direction (e.g., the direction x or the direction -x) in the first non-display area NDA1 may correspond to first island portions 11 arranged in the same row, for example, the (i)th row, in the display area DA (where i is a positive number greater than 0).

The display apparatus 1 may include third bridge portions 23 for connecting the display area DA and a first sub-non-display area SNDA1 to each other, the third bridge portions 23 arranged in a second sub-non-display area SNDA2. The non-display area, for example, the first non-display area NDA1, may include the first sub-non-display area SNDA1 in which the second island portions 21 and the second bridge portions 22 are arranged, and the second sub-non-display area SNDA2 including the third bridge portions 23 and between the first sub-non-display area SNDA1 and the display area DA. A third bridge portion 23 may be substantially the same as the first bridge portion 12 and the second bridge portion 22. For example, a width of the third bridge portion 23 may be the same as a width of the first bridge portion 12 and a width of the second bridge portion 22.

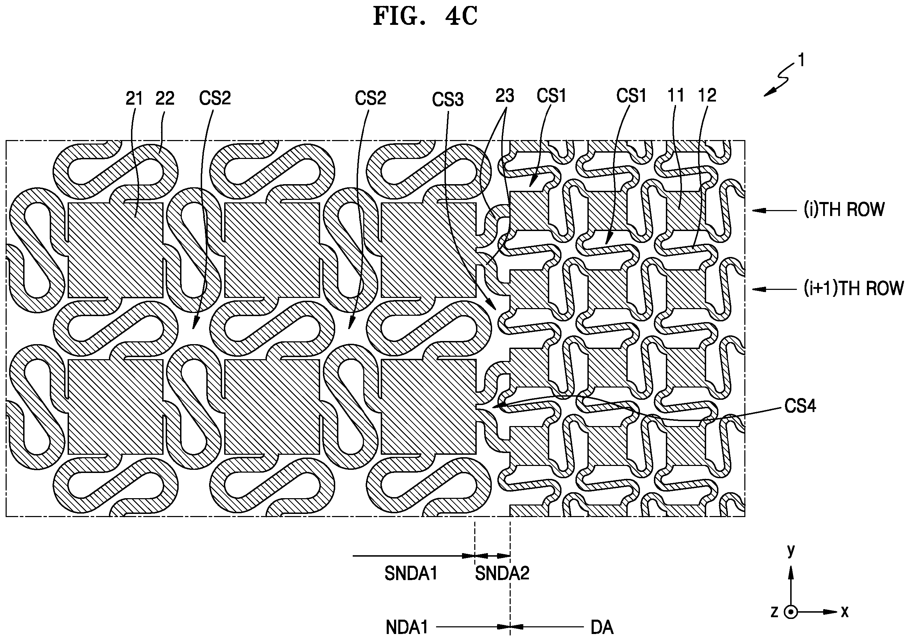

FIG. 4C is an enlarged plan view of the region IV of FIG. 3 as part of the display apparatus 1 according to an embodiment.

Referring to FIG. 4C, the display apparatus 1 may include first island portions 11 apart from each other in a first direction (e.g., the direction x or the direction -x) and a second direction (e.g., the direction y or the direction -y) in the display area DA and first bridge portions 12 connecting adjacent first island portions 11 to each other.

The first bridge portions 12 may be apart from each other due to a first opening portion CS1 between the first bridge portions 12. A first bridge portion 12 may have a serpentine shape. For example, as shown in FIG. 4C, the first bridge portion 12 may have approximately a shape of an alphabet 'S.'

Each first island portion 11 may be connected to a plurality of first bridge portions 12. For example, each first island portion 11 may be connected to four first bridge portions 12. Two first bridge portions 12 may be arranged on both sides of the first island portion 11 in the first direction (e.g., the direction x or the direction -x), and the other two first bridge portions 12 may be arranged on both sides of the first island portion 11 in the second direction (e.g., the direction y or the direction -y). The four first bridge portions 12 may be connected to four sides of the first island portion 11, respectively. Each of the four first bridge portions 12 may be adjacent to each corner of the first island portion 11.

The display apparatus 1 may include second island portions 21 apart from each other in the first direction (e.g., the direction x or the direction -x) and the second direction (e.g., the direction y or the direction -y) in a non-display area, for example, the first non-display area NDA1 shown in FIG. 4C, and second bridge portions 22 connecting adjacent second island portions 21 to each other.

The second bridge portions 22 may be apart from each other due to a second opening portion CS2 between the second bridge portions 22. A second bridge portion 22 may have a serpentine shape. For example, as shown in FIG. 4C, the second bridge portion 22 may have approximately a shape of an alphabet 'S.' A size and/or width of the second bridge portion 22 may be different from a size and/or width of the first bridge portion 12. For example, the size and/or width of the second bridge portion 22 may be greater than the size and/or width of the first bridge portion 12. A radius of curvature of a round portion of the second bridge portion 22 may be different from a radius of curvature of a round portion of the first bridge portion 12. For example, the radius of curvature of the round portion of the second bridge portion 22 may be greater than the radius of curvature of the round portion of the first bridge portion 12.

Each second island portion 21 may be connected to a plurality of second bridge portions 22. Each second island portion 21 may be connected to four second bridge portions 22. Two second bridge portions 22 may be arranged on both sides of the second island portion 21 in the first direction (e.g., the direction x or the direction -x), and the other two second bridge portions 22 may be arranged on both sides of the second island portion 21 in the second direction (e.g., the direction y or the direction -y). In an embodiment, the four second bridge portions 22 may be connected to four sides of the second island portion 21, respectively. Each second bridge portion 22 may be connected to a center of each side of the second island portion 21.

Second island portions 21 in any one row arranged in the first non-display area NDA1 may correspond to first island portions 11 in a plurality of rows arranged in the display area DA. For example, the second island portions 21 in any one row arranged in the first non-display area NDA1 may correspond to first island portions 11 arranged in a (i)th row and first island portions 11 arranged in a (i+1)th row in the display area DA (where i is a positive number greater than 0). In another embodiment, second island portions 21 in any one row may correspond to n rows of first island portions 11 (where n is a positive number equal to or greater than 3).

The non-display area, for example, the first non-display area NDA1, may include a first sub-non-display area SNDA1 in which the second island portions 21 and the second bridge portions 22 described above are arranged, and a second sub-non-display area SNDA2 between the first sub-non-display area SNDA1 and the display area DA. Third bridge portions 23 for connecting the display area DA and the first sub-non-display area SNDA1 to each other may be arranged in the second sub-non-display area SNDA2. One end of a third bridge portion 23 may be connected to the second island portion 21, and the other end of the third bridge portion 23 may be connected to the first island portion 11. For example, one end of the third bridge portion 23 may be connected to a center of one side of the second island portion 21, and the other end of the third bridge portion 23 may be connected to a center of one side of the first island portion 11.

The third bridge portion 23 may have a serpentine shape. In an embodiment, a shape of the third bridge portion 23 may be different from a shape of each of the first bridge portion 12 and the second bridge portion 22. A width of the third bridge portion 23 may be different from a width of the first bridge portion 12 and a width of the second bridge portion 22. The width of the third bridge portion 23 may be greater than the width of the first bridge portion 12 and less than the width of the second bridge portion 22. A third opening portion CS3 and a fourth opening portion CS4 of different shapes may alternate with each other between the third bridge portions 23 in the second direction (e.g., the direction y or the direction -y).

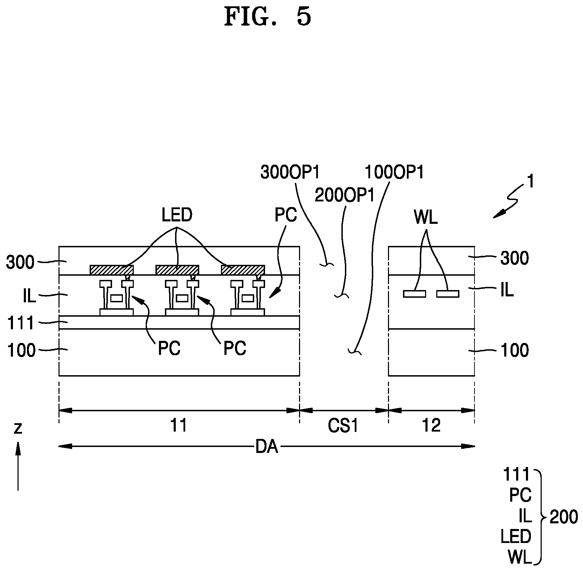

FIG. 5 is a schematic cross-sectional view of the first island portion 11 and the first bridge portion 12 arranged in the display area DA of the display apparatus 1 according to an embodiment.

Referring to FIG. 5, the first island portion 11 and the first bridge portion 12 arranged in the display area DA may be apart from each other with the first opening portion CS1 therebetween. The first island portion 11 may include light-emitting elements LED and a circuit, for example, a pixel driving circuit portion PC, electrically connected thereto and configured to drive a light-emitting element, and the first bridge portion 12 may include a wire WL electrically connected to pixel driving circuit portions PC arranged in each adjacent first island portion 11.

In regard to the first island portion 11, a buffer layer 111 including an inorganic insulating material may be disposed on a substrate 100, and the pixel driving circuit portion PC may be disposed on the buffer layer 111. A bottom insulating layer IL including an inorganic insulating material and/or an organic insulating material may be disposed between the pixel driving circuit portion PC and a light-emitting element LED. The light-emitting element LED may be disposed on the bottom insulating layer IL and may be electrically connected to a corresponding pixel driving circuit portion PC. The light-emitting elements LED may emit light of different colors from one another or may emit light of the same color. In an embodiment, the light-emitting elements LED may emit red light, green light, and blue light, respectively. In some embodiments, the light-emitting elements LED may emit white light. In another embodiment, the light-emitting elements LED may emit red light, green light, blue light, and white light, respectively.

The substrate 100 may include polymer resin, such as polyethersulfone, polyarylate, polyetherimide, polyethylene naphthalate, polyethylene terephthalate, polyphenylene sulfide, polyimide, polycarbonate, cellulose triacetate, or cellulose acetate propionate. In an embodiment, the substrate 100 may be a single layer including the above polymer resin. In another embodiment, the substrate 100 may have a multi-layer structure including a base layer including the above polymer resin and a barrier layer including an inorganic insulating material. The substrate 100 including polymer resin may be flexible, rollable and/or bendable.

As an embodiment, FIG. 5 shows three pixel driving circuit portions PC arranged in each first island portion 11 and three light-emitting elements LED connected to respective pixel driving circuit portions PC, but one or more embodiments are not limited thereto. In another embodiment, the numbers of pixel driving circuit portions PC and light-emitting elements LED arranged in the first island portion 11 may be one, two, or four or more.

An encapsulation layer 300 may be disposed on the light-emitting element LED and may protect the light-emitting element LED from external force and/or moisture permeation. The encapsulation layer 300 may include an inorganic encapsulation layer and/or an organic encapsulation layer. In some embodiments, the encapsulation layer 300 may include a structure in which an inorganic encapsulation layer including an inorganic insulating material, an organic encapsulation layer including an organic insulating material, and an inorganic encapsulation layer including an inorganic insulating material are stacked on one another. In another embodiment, the encapsulation layer 300 may include an organic material such as resin. In some embodiments, the encapsulation layer 300 may include urethane epoxy acrylate. The encapsulation layer 300 may include a photosensitive material, for example, a material such as photoresist.

In regard to the first bridge portion 12, the bottom insulating layer IL including an organic insulating material may be disposed on the substrate 100. The first bridge portion 12, which is relatively much deformed when the display apparatus 1 is stretched, may not have a layer including an inorganic insulating material prone to cracks, unlike the first island portion 11.

In an embodiment, the substrate 100 corresponding to the first bridge portion 12 may have the same stack structure as that of the substrate 100 corresponding to the first island portion 11. In an embodiment, the substrate 100 corresponding to the first bridge portion 12 and the substrate 100 corresponding to the first island portion 11 may be polymer resin layers formed together during the same process. In another embodiment, the substrate 100 corresponding to the first bridge portion 12 may have a different stack structure from that of the substrate 100 corresponding to the first island portion 11. In some embodiments, the substrate 100 corresponding to the first island portion 11 may have a multi-layer structure including a base layer including polymer resin and a barrier layer including an inorganic insulating material, and the substrate 100 corresponding to the first bridge portion 12 may have a structure of a polymer resin layer without a layer including an inorganic insulating material.

As described above, wires WL of the first bridge portion 12 may be signal lines (e.g., a gate line, a data line, etc.) for providing an electrical signal to a transistor included in the pixel driving circuit portion PC of the first island portion 11 or voltage lines (e.g., a driving voltage line, an initialization voltage line, etc.) for providing a voltage. The encapsulation layer 300 may also be arranged in the first bridge portion 12. In another embodiment, the encapsulation layer 300 may not be present in the first bridge portion 12.

Referring to FIGS. 4A to 4C and FIG. 5, the substrate 100 corresponding to the first island portion 11 and the substrate 100 corresponding to the first bridge portion 12 may be connected to each other. In other words, the plan views previously shown in FIGS. 4A to 4C may be substantially the same as a plan view of the substrate 100 of FIG. 5. In other words, the substrate 100 may include a region corresponding to the first island portion 11, a region corresponding to the first bridge portion 12, and an opening 100OP1 having the same shape as that of the first opening portion CS1.

Similarly, the encapsulation layer 300 corresponding to the first island portion 11 and the encapsulation layer 300 corresponding to the first bridge portion 12 may be connected to each other. For example, the plan views previously shown in FIGS. 4A to 4C may be substantially the same as a plan view of the encapsulation layer 300. In other words, the encapsulation layer 300 may include a region corresponding to the first island portion 11, a region corresponding to the first bridge portion 12, and an opening 300OP1 having the same shape as that of the first opening portion CS1.

A circuit-light-emitting element layer 200 between the substrate 100 and the encapsulation layer 300 may include the buffer layer 111, the pixel driving circuit portion PC, the wire WL, the bottom insulating layer IL, and the light-emitting element LED. Similar to the substrate 100, the plan views previously shown in FIGS. 4A to 4C may be substantially the same as a plan view of the circuit-light-emitting element layer 200. In other words, the circuit-light-emitting element layer 200 may include an opening 200OP1 having the same shape as that of the first opening portion CS1.

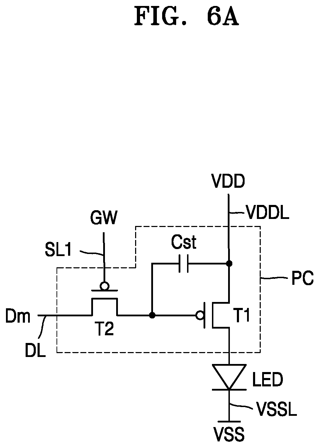

FIGS. 6A to 6C are each an equivalent circuit diagram of a sub-pixel of the display apparatus 1 according to an embodiment.

Referring to FIG. 6A, the light-emitting element LED corresponding to a sub-pixel may be electrically connected to the pixel driving circuit portion PC, and the pixel driving circuit portion PC may include a first transistor T1, a second transistor T2, and a storage capacitor Cst. The pixel driving circuit portion PC may be electrically connected to a signal line and a voltage line. The signal line may include a gate line such as a first scan line SL1 and a data line DL, and the voltage line may include a first voltage line VDDL.

The second transistor T2 may be electrically connected to the first scan line SL1 and the data line DL. The first scan line SL1 may be configured to provide a first scan signal GW to a gate electrode of the second transistor T2. The second transistor T2 may be configured to transmit a data signal Dm input from the data line DL to the first transistor T1 according to the first scan signal GW input from the first scan line SL1.

The storage capacitor Cst may be electrically connected to the second transistor T2 and the first voltage line VDDL and may store a voltage corresponding to a difference between a voltage received from the second transistor T2 and a first power voltage VDD supplied by the first voltage line VDDL.

The first transistor T1 is a driving transistor and may be configured to control a driving current flowing through the light-emitting element LED. The first transistor T1 may be connected to the first voltage line VDDL and the storage capacitor Cst. The first transistor T1 may be configured to control a driving current flowing from the first voltage line VDDL to the light-emitting element LED, in response to a voltage value stored in the storage capacitor Cst. The light-emitting element LED may emit light having certain brightness according to the driving current. A first electrode of the light-emitting element LED may be electrically connected to the first transistor T1, and a second electrode of the light-emitting element LED may be electrically connected to a second voltage line VSSL configured to supply a second power voltage VSS.

FIG. 6A shows the pixel driving circuit portion PC including two transistors and one storage capacitor. However, in another embodiment, the pixel driving circuit portion PC may include three or more transistors.

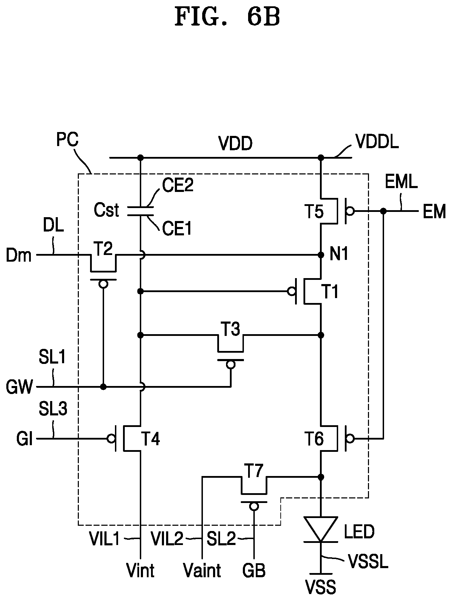

Referring to FIG. 6B, the pixel driving circuit portion PC may include the first transistor T1, the second transistor T2, a third transistor T3, a fourth transistor T4, a fifth transistor T5, a sixth transistor T6, a seventh transistor T7, and the storage capacitor Cst.

The pixel driving circuit portion PC is electrically connected to signal lines and voltage lines. The signal lines may include gate lines such as the first scan line SL1, a second scan line SL2, a third scan line SL3, a fourth scan line SL4, and an emission control line EML, and the data line DL. The voltage lines may include first and second initialization voltage lines VIL1 and VIL2 and the first voltage line VDDL.

The first voltage line VDDL may be configured to transfer the first power voltage VDD to the first transistor T1. The first initialization voltage line VIL1 may be configured to transfer a first initialization voltage Vint for initializing the first transistor T1 to the pixel driving circuit portion PC. The second initialization voltage line VIL2 may be configured to transfer a second initialization voltage Vaint for initializing a first electrode of the light-emitting element LED to the pixel driving circuit portion PC.

The first transistor T1 may be electrically connected to the first voltage line VDDL via the fifth transistor T5 and may be electrically connected to the light-emitting element LED via the sixth transistor T6. The first transistor T1 serves as a driving transistor and is configured to receive the data signal Dm according to a switching operation of the second transistor T2 and supply a driving current to the light-emitting element LED.

The second transistor T2 is a data writing transistor and is electrically connected to the first scan line SL1 and the data line DL. The second transistor T2 is electrically connected to the first voltage line VDDL via the fifth transistor T5. The second transistor T2 is turned on according to the first scan signal GW received through the first scan line SL1 to perform a switching operation for transmitting the data signal Dm transmitted through the data line DL to a first node N1.

The third transistor T3 is electrically connected to the first scan line SL1 and is electrically connected to the light-emitting element LED via the sixth transistor T6. The third transistor T3 may be turned on according to the first scan signal GW received through the first scan line SL1 to diode-connect the first transistor T1.

The fourth transistor T4 is a first initialization transistor and is electrically connected to the third scan line SL3 and the first initialization voltage line VIL1. The fourth transistor T4 is turned on according to a third scan signal GI received through the third scan line SL3 to transfer the first initialization voltage Vint from the first initialization voltage line VIL1 to a gate electrode of the first transistor T1 and initialize a voltage of the gate electrode of the first transistor T1. The third scan signal GI may be a first scan signal of another pixel driving circuit portion arranged in a previous row of the corresponding pixel driving circuit portion PC.

The fifth transistor T5 may be an operation control transistor, and the sixth transistor T6 may be an emission control transistor. The fifth transistor T5 and the sixth transistor T6 are electrically connected to the emission control line EML, and are simultaneously turned on according to an emission control signal EM received through the emission control line EML to form a current path that allows a driving current to flow in a direction from the first voltage line VDDL to the light-emitting element LED.

The seventh transistor T7 is a second initialization transistor and may be electrically connected to the second scan line SL2, the second initialization voltage line VIL2, and the sixth transistor T6. The seventh transistor T7 may be turned on according to a second scan signal GB received through the second scan line SL2 and may be configured to transfer the second initialization voltage Vaint from the second initialization voltage line VIL2 to the first electrode of the light-emitting element LED and initialize the first electrode of the light-emitting element LED.

The storage capacitor Cst includes a first electrode CE1 and a second electrode CE2. The first electrode CE1 is electrically connected to the gate electrode of the first transistor T1, and the second electrode CE2 is electrically connected to the first voltage line VDDL. The storage capacitor Cst may maintain a voltage applied to the gate electrode of the first transistor T1 by storing and maintaining a voltage corresponding to a voltage difference between two ends of the first voltage line VDDL and the gate electrode of the first transistor T1.

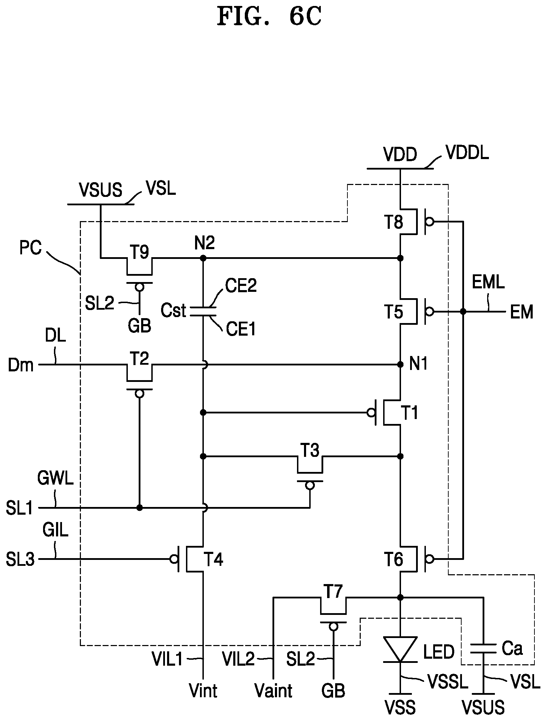

Referring to FIG. 6C, the pixel driving circuit portion PC may include the first transistor T1, the second transistor T2, the third transistor T3, the fourth transistor T4, the fifth transistor T5, the sixth transistor T6, the seventh transistor T7, an eighth transistor T8, a ninth transistor T9, the storage capacitor Cst, and an auxiliary capacitor Ca.

The pixel driving circuit portion PC is electrically connected to signal lines and voltage lines. The signal lines may include gate lines such as the first scan line SL1, the second scan line SL2, the third scan line SL3, the fourth scan line SL4, and the emission control line EML, and the data line DL. The voltage lines may include the first and second initialization voltage lines VIL1 and VIL2, a sustaining voltage line VSL, and the first voltage line VDDL.

The first voltage line VDDL may be configured to transfer the first power voltage VDD to the first transistor T1. The first initialization voltage line VIL1 may be configured to transfer the first initialization voltage Vint for initializing the first transistor T1 to the pixel driving circuit portion PC. The second initialization voltage line VIL2 may be configured to transfer the second initialization voltage Vaint for initializing a first electrode of the light-emitting element LED to the pixel driving circuit portion PC. The sustaining voltage line VSL may be configured to provide a sustaining voltage VSUS to a second node N2, for example, the second electrode CE2 of the storage capacitor Cst, during an initialization period and a data writing period.

The first transistor T1 may be electrically connected to the first voltage line VDDL via the fifth transistor T5 and the eighth transistor T8 and may be electrically connected to the light-emitting element LED via the sixth transistor T6. The first transistor T1 may serve as a driving transistor and may be configured to receive the data signal Dm according to a switching operation of the second transistor T2 and supply a driving current to the light-emitting element LED.

The second transistor T2 is electrically connected to the first scan line SL1 and the data line DL and is electrically connected to the first voltage line VDDL via the fifth transistor T5 and the eighth transistor T8. The second transistor T2 is turned on according to the first scan signal GW received through the first scan line SL1 to perform a switching operation for transmitting the data signal Dm transmitted through the data line DL to the first node N1.

The third transistor T3 is electrically connected to the first scan line SL1 and is electrically connected to the light-emitting element LED via the sixth transistor T6. The third transistor T3 may be turned on according to the first scan signal GW received through the first scan line SL1 to diode-connect the first transistor T1, thereby compensating for a threshold voltage of the first transistor T1.

The fourth transistor T4 is electrically connected to the third scan line SL3 and the first initialization voltage line VIL1, and is turned on according to the third scan signal GI received through the third scan line SL3 to transfer the first initialization voltage Vint from the first initialization voltage line VIL1 to a gate electrode of the first transistor T1 and initialize a voltage the gate electrode of the first transistor T1. The third scan signal GI may be a first scan signal of another pixel driving circuit portion arranged in a previous row of the corresponding pixel driving circuit portion PC.

The fifth transistor T5, the sixth transistor T6, and the eighth transistor T8 are electrically connected to the emission control line EML, and are simultaneously turned on according to the emission control signal EM received through the emission control line EML to form a current path that allows a driving current to flow in a direction from the first voltage line VDDL to the light-emitting element LED.

The seventh transistor T7 is a second initialization transistor and may be electrically connected to the second scan line SL2, the second initialization voltage line VIL2, and the sixth transistor T6. The seventh transistor T7 is turned on according to the second scan signal GB received through the second scan line SL2 to transfer the second initialization voltage Vaint from the second initialization voltage line VIL2 to the first electrode of the light-emitting element LED and initialize the first electrode of the light-emitting element LED.

The ninth transistor T9 may be electrically connected to the second scan line SL2, the second electrode CE2 of the storage capacitor Cst, and the sustaining voltage line VSL. The ninth transistor T9 may be turned on according to the second scan signal GB received through the second scan line SL2 and may be configured to transfer the sustaining voltage VSUS to the second node N2, for example, the second electrode CE2 of the storage capacitor Cst, during the initialization period and the data writing period.

The eighth transistor T8 and the ninth transistor T9 may each be electrically connected to the second node N2, for example, the second electrode CE2 of the storage capacitor Cst. In some embodiments, during an initialization period and a data writing period, the eighth transistor T8 may be turned off and the ninth transistor T9 may be turned on, and during an emission period, the eighth transistor T8 may be turned on and the ninth transistor T9 may be turned off. Because the sustaining voltage VSUS is transferred to the second node N2 during the initialization period and the data writing period, luminance uniformity (e.g., long range uniformity (LRU)) of a display apparatus according to a voltage drop of the first voltage line VDDL may be improved.

The storage capacitor Cst includes the first electrode CE1 and the second electrode CE2. The first electrode CE1 is electrically connected to the gate electrode of the first transistor T1, and the second electrode CE2 is electrically connected to the eighth transistor T8 and the ninth transistor T9.

The auxiliary capacitor Ca may be electrically connected to the sixth transistor T6, the sustaining voltage line VSL, and the first electrode of the light-emitting element LED. The auxiliary capacitor Ca may store and maintain a voltage corresponding to a voltage difference between the first electrode of the light-emitting element LED and the sustaining voltage line VSL while the seventh transistor T7 and the ninth transistor T9 are turned on, and thus, may prevent black luminance from rising when the sixth transistor T6 is off.

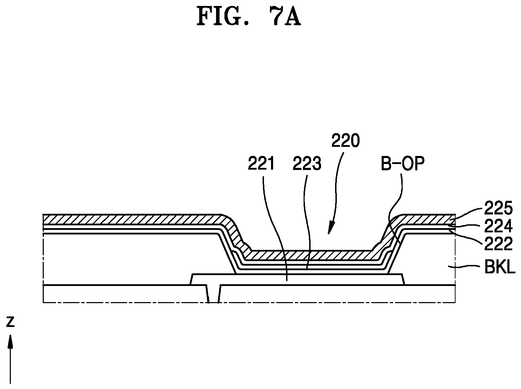

FIG. 7A is a schematic cross-sectional view of a light-emitting element of a display apparatus according to an embodiment.

Referring to FIG. 7A, a light-emitting element according to an embodiment may include an organic light-emitting diode 220 including an organic material. The organic light-emitting diode 220 may include a first electrode 221 disposed on an insulating layer, a second electrode 225 facing the first electrode 221, and an emission layer 223 disposed between the first electrode 221 and the second electrode 225. A first functional layer 222 may be disposed between the first electrode 221 and the emission layer 223, and a second functional layer 224 may be disposed between the emission layer 223 and the second electrode 225.

The edge of the first electrode 221 may be covered by a bank layer BKL including an insulating material. The bank layer BKL may include an opening B-OP overlapping a center portion of the first electrode 221.

The first electrode 221 may include conductive oxide, such as indium tin oxide (ITO), indium zinc oxide (IZO), zinc oxide (ZnO), indium oxide (In₂O₃), indium gallium oxide (IGO), or aluminum zinc oxide (AZO). In another embodiment, the first electrode 221 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof. In another embodiment, the first electrode 221 may further include a layer on/under the above-described reflective layer and formed of ITO, IZO, ZnO, AZO, or In₂O₃.

The emission layer 223 may include a high-molecular weight or low-molecular weight organic material emitting light of a certain color. The first functional layer 222 may include a hole transport layer (HTL) and/or a hole injection layer (HIL). The second functional layer 224 may include an electron transport layer (ETL) and/or an electron injection layer (EIL).

The second electrode 225 may include a conductive material having a low work function. For example, the second electrode 225 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the second electrode 225 may further include a layer, such as ITO, IZO, ZnO, AZO, or In₂O₃, on a (semi)transparent layer including the above-described material.

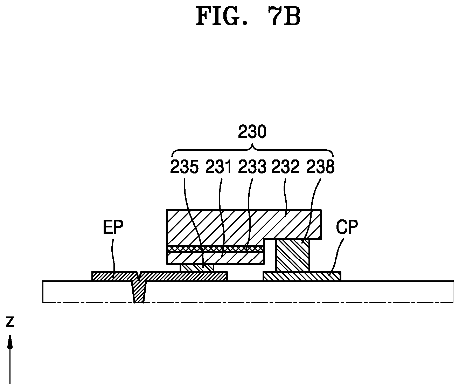

FIG. 7B is a schematic cross-sectional view of a light-emitting element of a display apparatus according to an embodiment.

Referring to FIG. 7B, a light-emitting element according to an embodiment may include an inorganic light-emitting diode 230 including an inorganic material. The inorganic light-emitting diode 230 may include a first semiconductor layer 231, a second semiconductor layer 232, an intermediate layer 233 between the first semiconductor layer 231 and the second semiconductor layer 232, a first electrode 235 electrically connected to the first semiconductor layer 231, and a second electrode 238 electrically connected to the second semiconductor layer 232.

The first electrode 235 and the second electrode 238 of the inorganic light-emitting diode 230 may face the same direction. Both of the first electrode 235 and the second electrode 238 may be disposed below the intermediate layer 233. Accordingly, the first electrode 235 and the second electrode 238 of the inorganic light-emitting diode 230 of FIG. 7B may be directly connected to an electrode pad EP and a common electrode pad CP, respectively, disposed on the same layer.

In some embodiments, the first semiconductor layer 231 may include a p-type semiconductor layer. The p-type semiconductor layer may be selected from semiconductor materials having a composition formula of InₓAl_{y}Ga_{1-x-y}N (0≤x≤1, 0≤y≤1, 0≤x+y≤1), for example, GaN, AIN, AlGaN, InGaN, InN, InAlGaN, AlInN, etc., and may be doped with a p-type dopant such as Mg, Zn, Ca, Sr, Ba, etc.

The second semiconductor layer 232 may include, for example, an n-type semiconductor layer. The n-type semiconductor layer may be selected from semiconductor materials having a composition formula of InₓAl_{y}Ga_{1-x-y}N (0≤x≤1, 0≤y≤1, 0≤x+y≤1), for example, GaN, AIN, AlGaN, InGaN, InN, InAlGaN, AlInN, etc., and may be doped with an n-type dopant such as Si, Ge, Sn, etc.

The intermediate layer 233 is an area where electrons and holes recombine with each other, and transition to a lower energy level when the electrons and the holes recombine, and accordingly, light having a wavelength corresponding to the transitioned energy level is emitted. The intermediate layer 233 may include, for example, a semiconductor material having a composition formula of InₓAl_{y}Ga_{1-x-y}N (0≤x≤1, 0≤y≤1, 0≤x+y≤1), and may have a single quantum well structure or a multi-quantum well (MQW) structure. In addition, the intermediate layer 233 may include a quantum wire structure or a quantum dot structure.

Although FIG. 7B illustrates that the first semiconductor layer 231 includes a p-type semiconductor layer and the second semiconductor layer 232 includes an n-type semiconductor layer, one or more embodiments are not limited thereto. In another embodiment, the first semiconductor layer 231 may include an n-type semiconductor layer, and the second semiconductor layer 232 may include a p-type semiconductor layer.

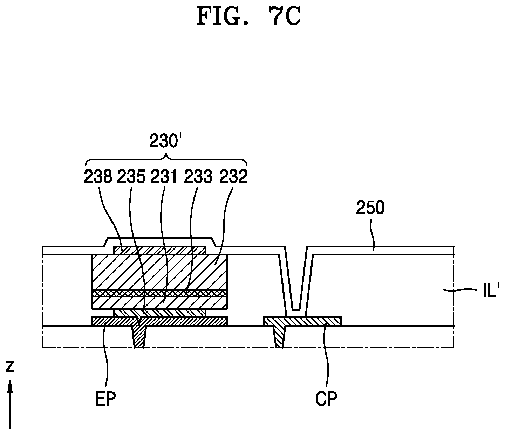

FIG. 7C is a schematic cross-sectional view of a light-emitting element of a display apparatus according to an embodiment. In FIG. 7C, elements that are the same as those in FIG. 7B are designated by the same reference numerals.

Referring to FIG. 7C, an inorganic light-emitting diode 230' may include the first semiconductor layer 231, the second semiconductor layer 232, the intermediate layer 233 between the first semiconductor layer 231 and the second semiconductor layer 232, the first electrode 235 electrically connected to the first semiconductor layer 231, and the second electrode 238 electrically connected to the second semiconductor layer 232. The first electrode 235 and the second electrode 238 of the inorganic light-emitting diode 230' may be electrically connected to the electrode pad EP and the common electrode pad CP, respectively, disposed on the same layer.

The first electrode 235 and the second electrode 238 of the inorganic light-emitting diode 230' of FIG. 7C may face different directions from each other. The first electrode 235 may be disposed below the intermediate layer 233, and the second electrode 238 may be disposed above the intermediate layer 233. The second electrode 238 may be electrically connected to the common electrode pad CP through a common electrode 250.

A top insulating layer IL' may be disposed between the common electrode pad CP and the common electrode 250. The top insulating layer IL' may cover the inorganic light-emitting diode 230' but expose the second electrode 238 of the inorganic light-emitting diode 230'. The common electrode 250 may be disposed on the top insulating layer IL' and may be directly connected to the second electrode 238. The top insulating layer IL' may include a contact hole exposing the common electrode pad CP. The common electrode 250 may be connected to the common electrode pad CP through the contact hole. The second electrode 238 may be electrically connected to the common electrode pad CP through the common electrode 250.

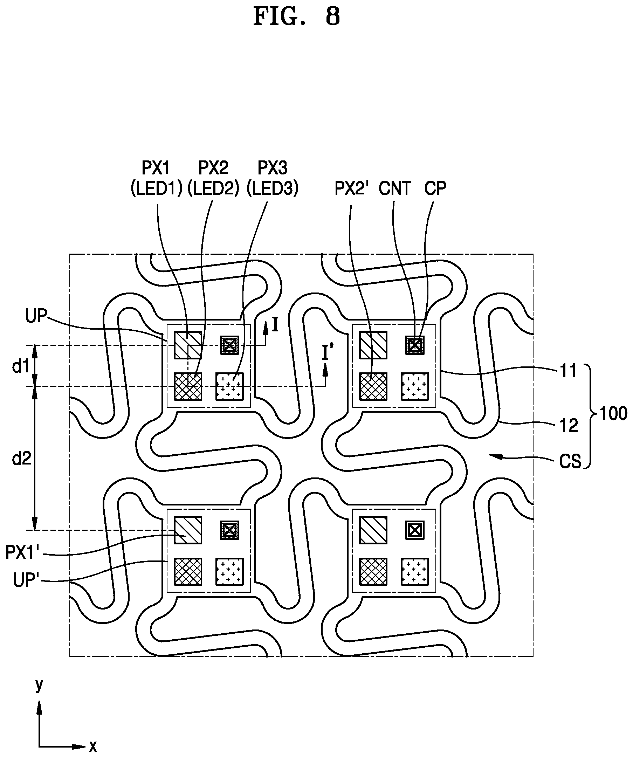

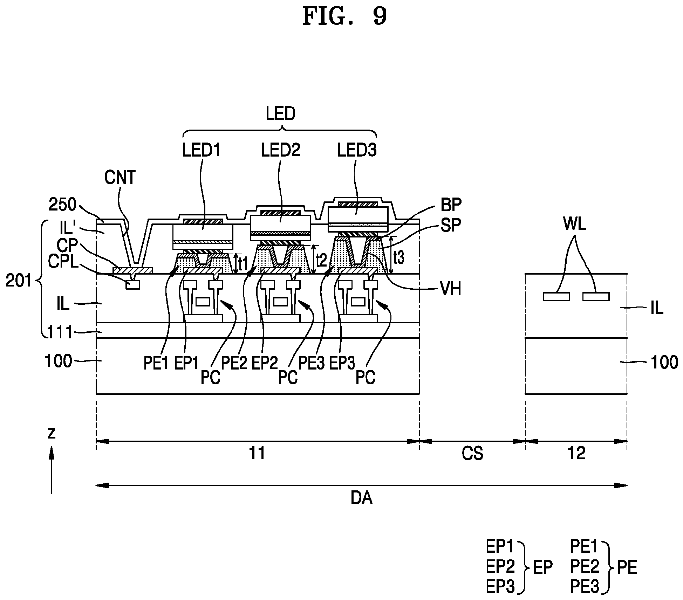

FIG. 8 is a plan view of a portion of a display apparatus according to an embodiment. FIG. 9 is a schematic cross-sectional view of a portion of the display apparatus of FIG. 8, taken along a line I-I' of FIG. 8.

Referring to FIG. 8, the substrate 100 of the display apparatus may include a plurality of island portions 11, a plurality of bridge portions 12, and an opening portion CS. A unit pixel UP may be arranged in each of the plurality of island portions 11.

A plurality of unit pixels UP may be repeatedly arranged in the direction x and the direction y. The unit pixel UP may include a first sub-pixel PX1, a second sub-pixel PX2, and a third sub-pixel PX3 that implement different colors from one another. The first sub-pixel PX1, the second sub-pixel PX2, and the third sub-pixel PX3 may be red, green and blue pixels, respectively.

The first sub-pixel PX1 may be implemented by a first light-emitting element LED1, the second sub-pixel PX2 may be implemented by a second light-emitting element LED2, and the third sub-pixel PX3 may be implemented by a third light-emitting element LED3. The first light-emitting element LED1, the second light-emitting element LED2, and the third light-emitting element LED3 may be the inorganic light-emitting diodes 230 and 230' of FIG. 7B or 7C.

All of the first sub-pixel PX1, the second sub-pixel PX2, and the third sub-pixel PX3 included in one unit pixel UP may be arranged in one island portion 11. The first sub-pixel PX1 and the second sub-pixel PX2 may be arranged in the direction y, and the second sub-pixel PX2 and the third sub-pixel PX3 may be arranged in the direction x. The first sub-pixel PX1, the second sub-pixel PX2, and the third sub-pixel PX3 may be arranged in correspondence with the vertices of a virtual right triangle.

The first sub-pixel PX1 and the second sub-pixel PX2 may alternate with each other in the direction y. In this case, a center distance d1 between the second sub-pixel PX2 and the first sub-pixel PX1 arranged at an upper side thereof (in a direction +y) may be less than a center distance d2 between the second sub-pixel PX2 and a first sub-pixel PX1' arranged at a lower side thereof (in the direction -y).

In other words, the center distance d2 between the first sub-pixel PX1' included in a unit pixel UP' adjacent in the direction y and the second sub-pixel PX2 may be greater than the center distance d1 between the first sub-pixel PX1 and the second sub-pixel PX2 included in the same unit pixel UP.

The second sub-pixel PX2 and the third sub-pixel PX3 may alternate with each other in the direction x. In this case, a center distance between the third sub-pixel PX3 and the second sub-pixel PX2 arranged at a left side thereof (in the direction -x) may be less than a center distance between the third sub-pixel PX3 and a second sub-pixel PX2' arranged at a right side thereof (in a direction +x).

In other words, the center distance between the second sub-pixel PX2' included in a unit pixel adjacent in the direction x and the third sub-pixel PX3 may be greater than the center distance between the second sub-pixel PX2 and the third sub-pixel PX3 included in the same unit pixel UP.

A contact hole CNT may be arranged in the island portion 11. The contact hole CNT may expose a portion of the common electrode pad CP below. The common electrode 250 (refer to FIG. 9) and the common electrode pad CP may be connected to each other through the contact hole CNT.

Referring to FIG. 9, in the display apparatus according to the present embodiment, light-emitting elements LED may be arranged in the island portion 11 of the substrate 100, and protruding electrodes PE connected to the light-emitting elements LED may be disposed between the substrate 100 and the light-emitting elements LED.

The light-emitting elements LED may include the first light-emitting element LED1, the second light-emitting element LED2, and the third light-emitting element LED3. The first light-emitting element LED1, the second light-emitting element LED2, and the third light-emitting element LED3 may emit light of different colors from one another. For example, the first light-emitting element LED1, the second light-emitting element LED2, and the third light-emitting element LED3 may emit red light, green light, and blue light, respectively.

A circuit layer 201 may be arranged in the island portion 11, and the circuit layer 201 may include the buffer layer 111, the pixel driving circuit portion PC, and the bottom insulating layer IL. The pixel driving circuit portion PC may include a plurality of pixel driving circuit portions PC, and the plurality of pixel driving circuit portions PC may be connected to the light-emitting elements LED, respectively. The bottom insulating layer IL may cover the pixel driving circuit portion PC and provide a flat upper surface.

A first electrode pad EP1, a second electrode pad EP2, a third electrode pad EP3, and the common electrode pad CP may be disposed on the bottom insulating layer IL. The first electrode pad EP1 may be electrically connected to the first light-emitting element LED1 and may be an intermediate medium that electrically connects the first light-emitting element LED1 and the pixel driving circuit portion PC to each other. The second electrode pad EP2 may be electrically connected to the second light-emitting element LED2 and may be an intermediate medium that electrically connects the second light-emitting element LED2 and the pixel driving circuit portion PC to each other. The third electrode pad EP3 may be electrically connected to the third light-emitting element LED3 and may be an intermediate medium that electrically connects the third light-emitting element LED3 and the pixel driving circuit portion PC to each other. The common electrode pad CP may be connected to a common voltage line CPL disposed below. The common voltage line CPL may be configured to provide the second power voltage VSS (refer to FIG. 6A). The common electrode pad CP may be in contact with the common electrode 250 through the contact hole CNT defined in the top insulating layer IL'.

The first to third electrode pads EP1 to EP3 and the common electrode pad CP may include a conductive material. The first to third electrode pads EP1 to EP3 and the common electrode pad CP may include silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), titanium (Ti), or an alloy thereof. Alternatively, the first to third electrode pads EP1 to EP3 and the common electrode pad CP may further include a layer, such as ITO, IZO, ZnO, AZO, or In₂O₃, on a conductive layer including the above-described material.

The protruding electrodes PE may protrude from an upper portion of the bottom insulating layer IL while covering electrode pads EP. The electrode pads EP may include the first electrode pad EP1, the second electrode pad EP2, and the third electrode pad EP3.

Each of the protruding electrodes PE may include a protrusion SP and a bonding pad BP disposed on the protrusion SP. The protrusion SP may include an organic insulating material. The protrusion SP may include a via hole VH, and the bonding pad BP may be inserted in the via hole VH.

The bonding pad BP may be connected to the electrode pads EP disposed under the protruding electrode PE through the via hole VH. The bonding pad BP may include a conductive material. The bonding pad BP may include silver (Ag), copper (Cu), tin (Sn), aluminum (Al), platinum (Pt), palladium (Pd), gold (Au), nickel (Ni), titanium (Ti), or an alloy thereof.

The protruding electrodes PE may include a first protruding electrode PE1, a second protruding electrode PE2, and a third protruding electrode PE3. In some embodiments, the protruding electrodes PE may be apart from one another.

The first protruding electrode PE1 may be connected to the first electrode pad EP1. The protrusion SP of the first protruding electrode PE1 may cover the edge of the first electrode pad EP1, and the via hole VH in the first protruding electrode PE1 may expose a center of the first electrode pad EP1. The bonding pad BP of the first protruding electrode PE1 may be in contact with the first electrode pad EP1 through the via hole VH. The bonding pad BP of the first protruding electrode PE1 may be connected to a first electrode of the first light-emitting element LED1.

The second protruding electrode PE2 may be connected to the second electrode pad EP2. The protrusion SP of the second protruding electrode PE2 may cover the edge of the second electrode pad EP2, and the via hole VH in the second protruding electrode PE2 may expose a center of the second electrode pad EP2. The bonding pad BP of the second protruding electrode PE2 may be in contact with the second electrode pad EP2 through the via hole VH. The bonding pad BP of the second protruding electrode PE2 may be connected to a first electrode of the second light-emitting element LED2.

The third protruding electrode PE3 may be connected to the third electrode pad EP3. The protrusion SP of the third protruding electrode PE3 may cover the edge of the third electrode pad EP3, and the via hole VH in the third protruding electrode PE3 may expose a center of the third electrode pad EP3. The bonding pad BP of the third protruding electrode PE3 may be in contact with the third electrode pad EP3 through the via hole VH. The bonding pad BP of the third protruding electrode PE3 may be connected to a first electrode of the third light-emitting element LED3.

In the present embodiment, the first protruding electrode PE1, the second protruding electrode PE2, and the third protruding electrode PE3 may have different thicknesses or different heights from an upper surface of the substrate 100. In the present description, a thickness of the protruding electrode PE refers to a value obtained by measuring a maximum distance from a lower surface of the protrusion SP to an upper surface of the bonding pad BP in a direction perpendicular to the upper surface of the substrate 100.

A thickness t1 of the first protruding electrode PE1 may be different from a thickness t2 of the second protruding electrode PE2. The thickness t2 of the second protruding electrode PE2 may be different from a thickness t3 of the third protruding electrode PE3. The first protruding electrode PE1, the second protruding electrode PE2, and the third protruding electrode PE3 may have different heights with respect to the upper surface of the substrate 100, thereby causing a step difference.

For example, the thickness t1 of the first protruding electrode PE1 may be about 5 µm to about 7 µm. The thickness t2 of the second protruding electrode PE2 may be about 10 µm to about 12 µm. The thickness t3 of the third protruding electrode PE3 may be about 15 µm to about 17 µm. A height difference between the first protruding electrode PE1 and the second protruding electrode PE2 may be about 3 µm to about 7 µm. A height difference between the second protruding electrode PE2 and the third protruding electrode PE3 may be about 3 µm to about 7 µm.

Because the display apparatus according to the present embodiments includes such protruding electrodes PE, the light-emitting elements LED may be easily arranged. A detailed description thereof is given later.

The first light-emitting element LED1, the second light-emitting element LED2, and the third light-emitting element LED3 may be connected to the first protruding electrode PE1, the second protruding electrode PE2, and the third protruding electrode PE3, respectively, and may be disposed thereon.

The top insulating layer IL' may cover at least a portion of the first light-emitting element LED1, the second light-emitting element LED2, and the third light-emitting element LED3. The top insulating layer IL' may expose second electrodes of the first light-emitting element LED1, the second light-emitting element LED2, and the third light-emitting element LED3. The common electrode 250 may be disposed on the top insulating layer IL' and connected to the second electrode of the first light-emitting element LED1, the second electrode of the second light-emitting element LED2, and the second electrode of the third light-emitting element LED3. The common electrode 250 may be connected to the common electrode pad CP through the contact hole CNT defined in the top insulating layer IL'. The top insulating layer IL' may include an organic insulating material.

The common electrode 250 may include a conductive material. For example, the common electrode 250 may include silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the common electrode 250 may further include a layer, such as ITO, IZO, ZnO, AZO, or In₂O₃, on a conductive layer including the above-described material. Alternatively, the common electrode 250 may include only a transparent conductive material including ITO, IZO, ZnO, AZO, or In₂O₃.

The wires WL may be arranged in a bridge portion 12 of the substrate 100. The wires WL may be configured to transfer various signals and a power voltage to the pixel driving circuit portion PC.

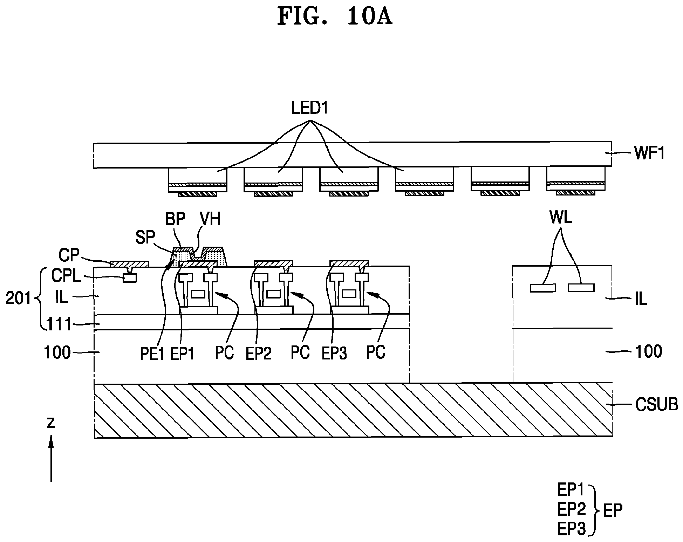

FIGS. 10A to 10F are schematic cross-sectional views sequentially showing a method of manufacturing a display apparatus, according to an embodiment.

Referring to FIG. 10A, the circuit layer 201 including the pixel driving circuit portion PC is formed on the substrate 100 supported by a carrier substrate CSUB, and the first electrode pad EP1, the second electrode pad EP2, the third electrode pad EP3, and the common electrode pad CP are formed on the circuit layer 201.

Next, the first protruding electrode PE1 is formed in correspondence with the first electrode pad EP1. To form the first protruding electrode PE1, an organic insulating material such as a photoresist may be spread on the first electrode pad EP1 and then patterned through a photomask process to form the protrusion SP including the via hole VH. Next, the bonding pad BP is formed on the protrusion SP. By forming the first protruding electrode PE1, only the first light-emitting element LED1 brought into contact with the first protruding electrode PE1 may be selectively transferred.

Next, a first support substrate WF1 on which first light-emitting elements LED1 are disposed is placed to face the substrate 100. The first support substrate WF1 may be a wafer on which the first light-emitting elements LED1 may grow. That is, the first light-emitting elements LED1 may be formed by epitaxial growth on the first support substrate WF1. However, one or more embodiments are not limited thereto. The first support substrate WF1 may be a temporary substrate onto which the first light-emitting elements LED1 grown on a wafer are transferred.

The first light-emitting elements LED1 may be light-emitting elements all emitting light of the same color. For example, the first light-emitting elements LED1 may be inorganic light-emitting diodes emitting red light.

The first light-emitting element LED1 at a position corresponding to the first protruding electrode PE1 may be transferred from the first support substrate WF1 through eutectic bonding. To perform eutectic bonding, the first protruding electrode PE1 and a first electrode of the first light-emitting element LED1 may be brought into contact with each other, and then, a certain heat may be applied to melt the bonding pad BP. The bonding pad BP may include an alloy that may be melted at low temperature. The first protruding electrode PE1 and the first light-emitting element LED1 may be bonded to each other through a process in which the bonding pad BP is melted and then hardened again.

Because the first protruding electrode PE1 is provided in correspondence with the first electrode pad EP1, the first light-emitting elements LED1 may not come into contact with the second electrode pad EP2 or the third electrode pad EP3, and thus, the first light-emitting elements LED1 may not be transferred to the second electrode pad EP2 or the third electrode pad EP3.

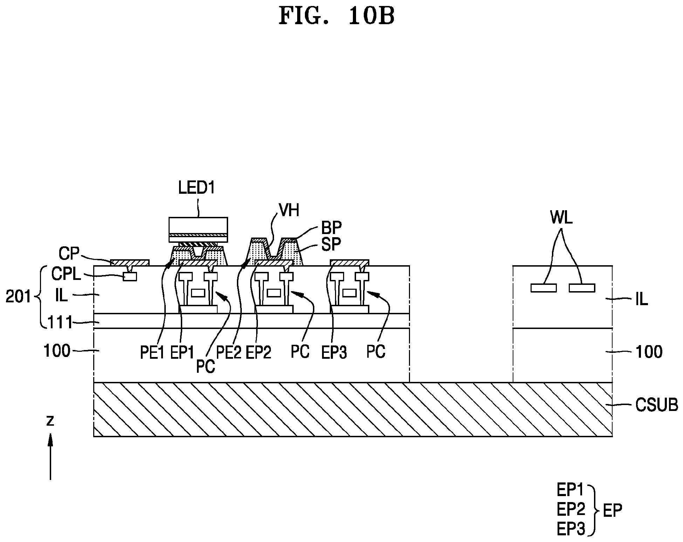

Referring to FIG. 10B, after the first light-emitting element LED1 is transferred to the first protruding electrode PE1, the second protruding electrode PE2 is formed on the substrate 100. A thickness of the second protruding electrode PE2 may be greater than a thickness of the first protruding electrode PE1. By forming the second protruding electrode PE2, only the second light-emitting element LED2 brought into contact with the second protruding electrode PE2 may be selectively transferred. Accordingly, when the second light-emitting element LED2 is transferred, interference with the already bonded first light-emitting element LED1 may be reduced. The second protruding electrode PE2 may be formed through the same process as that of the first protruding electrode PE1.

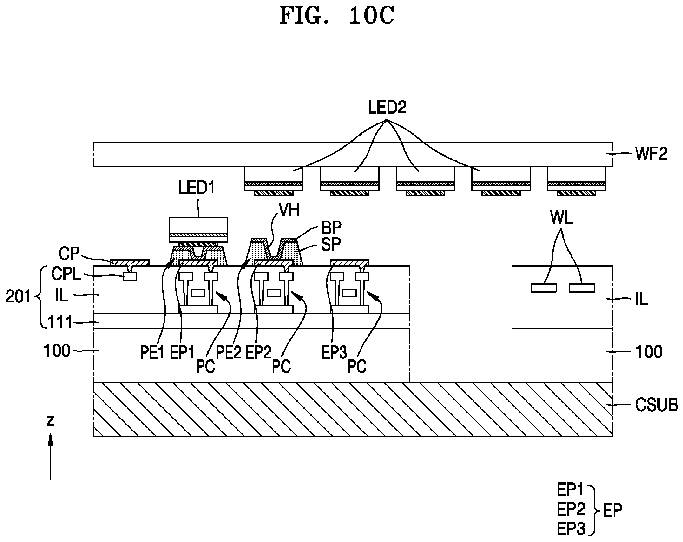

Next, referring to FIG. 10C, a second support substrate WF2 on which second light-emitting elements LED2 are disposed is placed to face the substrate 100. The second support substrate WF2 may be a wafer on which the second light-emitting elements LED2 may grow. For example, the second light-emitting elements LED2 may be formed by epitaxial growth on the second support substrate WF2. However, one or more embodiments are not limited thereto. The second support substrate WF2 may be a temporary substrate onto which the second light-emitting elements LED2 grown on a wafer are transferred.

The second light-emitting elements LED2 may be light-emitting elements all emitting light of the same color. For example, the second light-emitting elements LED2 may be inorganic light-emitting diodes emitting green light. For the second support substrate WF2, a region corresponding to the first protruding electrode PE1 or a region corresponding to the already bonded first light-emitting element LED1 may be empty without the second light-emitting element LED2 arranged therein.

The second light-emitting element LED2 at a position corresponding to the second protruding electrode PE2 may be transferred from the second support substrate WF2 through eutectic bonding. To perform eutectic bonding, the second protruding electrode PE2 and a first electrode of the second light-emitting element LED2 may be brought into contact with each other, and then, a certain heat may be applied to bond the first electrode of the second light-emitting element LED2 and the bonding pad BP to each other.

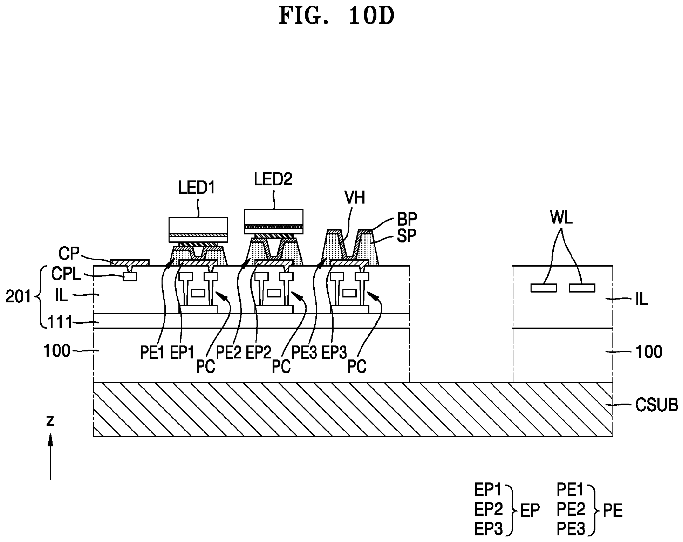

Referring to FIG. 10D, after the second light-emitting element LED2 is transferred to the second protruding electrode PE2, the third protruding electrode PE3 is formed on the substrate 100. A thickness of the third protruding electrode PE3 may be greater than the thickness of the second protruding electrode PE2. By forming the third protruding electrode PE3, only the third light-emitting element LED3 brought into contact with the third protruding electrode PE3 may be selectively transferred. Accordingly, when the third light-emitting element LED3 is transferred, interference with the already bonded first light-emitting element LED1 and second light-emitting element LED2 may be reduced. The third protruding electrode PE3 may be formed through the same process as that of the first protruding electrode PE1.

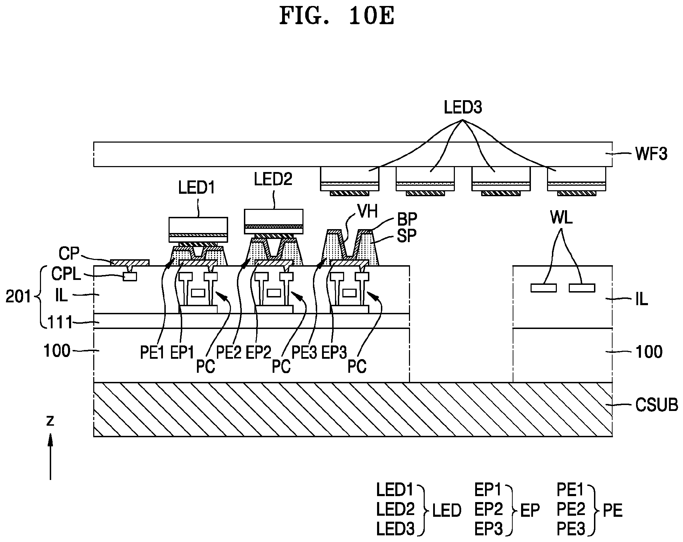

Next, referring to FIG. 10E, a third support substrate WF3 on which third light-emitting elements LED3 are disposed is placed to face the substrate 100. The third support substrate WF3 may be a wafer on which the third light-emitting elements LED3 may grow. That is, the third light-emitting elements LED3 may be formed by epitaxial growth on the third support substrate WF3. However, one or more embodiments are not limited thereto. The third support substrate WF3 may be a temporary substrate onto which the third light-emitting elements LED3 grown on a wafer are transferred.

The third light-emitting elements LED3 may be light-emitting elements all emitting light of the same color. For example, the third light-emitting elements LED3 may be inorganic light-emitting diodes emitting blue light. For the third support substrate WF3, a region corresponding to the first protruding electrode PE1 or a region corresponding to the second protruding electrode PE2 may be empty without the third light-emitting element LED3 arranged therein.

The third light-emitting element LED3 at a position corresponding to the third protruding electrode PE3 may be transferred from the third support substrate WF3 through eutectic bonding. To perform eutectic bonding, the third protruding electrode PE3 and a first electrode of the third light-emitting element LED3 may be brought into contact with each other, and then, a certain heat may be applied to bond the first electrode of the third light-emitting element LED3 and the bonding pad BP to each other.

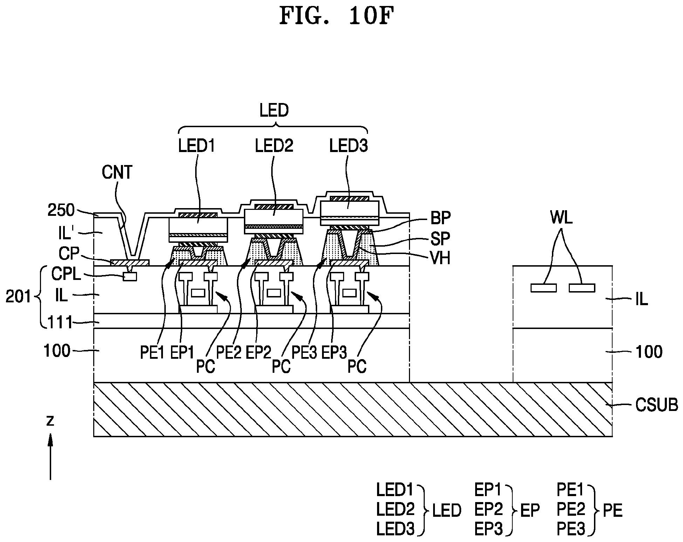

Referring to FIG. 10F, the top insulating layer IL' at least partially covering the first light-emitting element LED1, the second light-emitting element LED2, and the third light-emitting element LED3 is formed. The top insulating layer IL' may include an organic insulating material. The top insulating layer IL' may include the contact hole CNT exposing the common electrode pad CP. The top insulating layer IL' may expose respective second electrodes of the first light-emitting element LED1, the second light-emitting element LED2, and the third light-emitting element LED3. The second electrodes may be formed after the first light-emitting element LED1, the second light-emitting element LED2, and the third light-emitting element LED3 are transferred.

Alternatively, the second electrodes may not be formed on the first light-emitting element LED1, the second light-emitting element LED2, and the third light-emitting element LED3, and the common electrode 250 may be in direct contact with the second semiconductor layer 232 (refer to FIG. 7C) of each light-emitting element.

The common electrode 250 connected to the respective second electrodes of the first light-emitting element LED1, the second light-emitting element LED2, and the third light-emitting element LED3 is formed on the top insulating layer IL'. The common electrode 250 may be connected to the common electrode pad CP through the contact hole CNT. The carrier substrate CSUB supporting a display apparatus during the transfer process may be removed later.

A display apparatus according to one or more embodiments may include a protruding electrode, so that light-emitting elements grown by epitaxial growth on a wafer may be selectively transferred directly to a substrate of the display apparatus, thereby improving precision of a transfer process and reducing process costs.

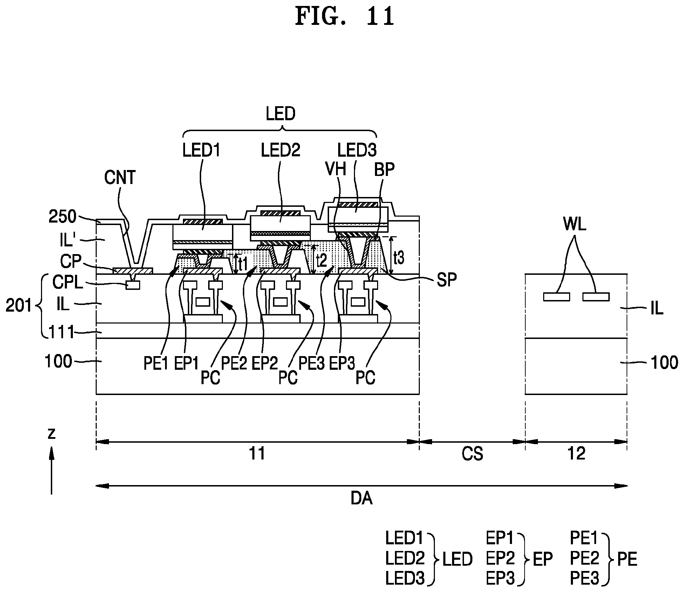

FIG. 11 is a schematic cross-sectional view of a display apparatus according to an embodiment. In FIG. 11, elements that are the same as those in FIG. 9 are designated by the same reference numerals.

Referring to FIG. 11, in the display apparatus according to the present embodiment, light-emitting elements LED may be arranged in the island portion 11 of the substrate 100, and protruding electrodes PE connected to the light-emitting elements LED may be disposed between the substrate 100 and the light-emitting elements LED.

The protruding electrode PE may include the protrusion SP and the bonding pad BP. The protrusion SP may include an organic insulating material. The protrusion SP may include the via hole VH, and the bonding pad BP may be inserted in the via hole VH.

The protruding electrodes PE may include the first protruding electrode PE1, the second protruding electrode PE2, and the third protruding electrode PE3.

The first protruding electrode PE1, the second protruding electrode PE2, and the third protruding electrode PE3 may have different thicknesses or different heights from an upper surface of the substrate 100. The thickness t1 of the first protruding electrode PE1 may be different from the thickness t2 of the second protruding electrode PE2. The thickness t2 of the second protruding electrode PE2 may be different from the thickness t3 of the third protruding electrode PE3. The first protruding electrode PE1, the second protruding electrode PE2, and the third protruding electrode PE3 may have different heights with respect to the upper surface of the substrate 100, thereby causing a step difference. Because the protruding electrodes PE have a step difference from one another, the light-emitting elements LED may be easily arranged.

In the present embodiment, protrusions SP of the protruding electrodes PE may be connected to one another. For example, the protrusion SP of the second protruding electrode PE2 may cover at least a portion of the protrusion SP of the first protruding electrode PE1. In this case, the thickness t2 of the second protruding electrode PE2 may be greater than the thickness t1 of the first protruding electrode PE1.

The protrusion SP of the third protruding electrode PE3 may cover at least a portion of the protrusion SP of the second protruding electrode PE2. The thickness t3 of the third protruding electrode PE3 may be greater than the thickness t2 of the second protruding electrode PE2. As described above, the protruding electrodes PE may be connected to support one another. In addition, because the protruding electrodes PE may be arranged close to one another, resolution of the display apparatus may be increased compared to a structure in which the protruding electrodes PE are apart from one another.

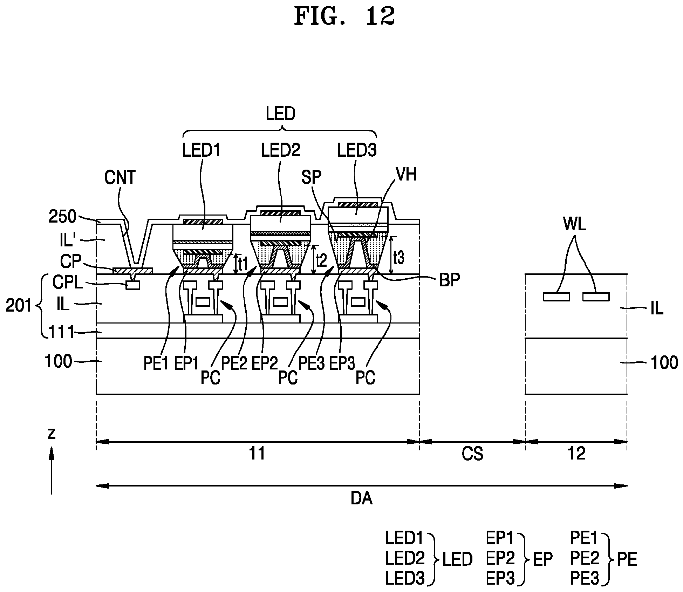

FIG. 12 is a schematic cross-sectional view of a display apparatus according to an embodiment. In FIG. 12, elements that are the same as those in FIG. 9 are designated by the same reference numerals.

Referring to FIG. 12, in the display apparatus according to the present embodiment, light-emitting elements LED may be arranged in the island portion 11 of the substrate 100, and protruding electrodes PE connected to the light-emitting elements LED may be disposed between the substrate 100 and the light-emitting elements LED.

The protruding electrode PE may include the protrusion SP and the bonding pad BP. The protrusion SP may include an organic insulating material. The protrusion SP may include the via hole VH, and the bonding pad BP may be inserted in the via hole VH.

In the present embodiment, the protruding electrodes PE may be formed for the light-emitting elements LED, respectively. That is, the protrusion SP of the protruding electrodes PE may protrude from a lower portion of the light-emitting elements LED, and the bonding pad BP may be disposed under the protrusion SP.

The protrusion SP of the protruding electrode PE may cover a first electrode of the light-emitting element LED, and the bonding pad BP may be in contact with the first electrode of the light-emitting element LED through the via hole VH. Flat surfaces of bonding pads BP may be connected to the first to third electrode pads EP1 to EP3 disposed above the substrate 100.

The thickness t1 of the first protruding electrode PE1 may be different from the thickness t2 of the second protruding electrode PE2. The thickness t2 of the second protruding electrode PE2 may be different from the thickness t3 of the third protruding electrode PE3. The first protruding electrode PE1, the second protruding electrode PE2, and the third protruding electrode PE3 may have different heights with respect to the upper surface of the substrate 100, thereby causing a step difference. Because the protruding electrodes PE have a step difference from one another, the light-emitting elements LED may be easily arranged.

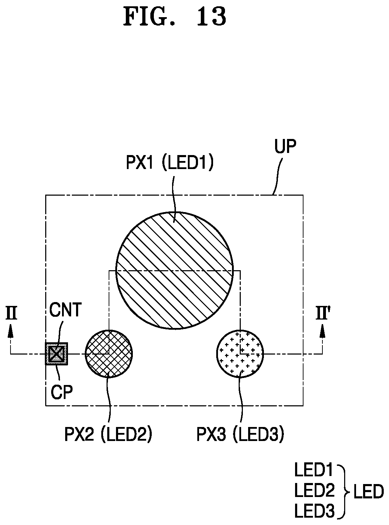

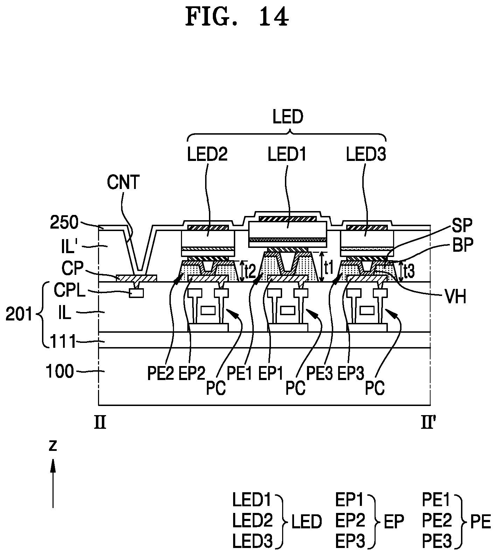

FIG. 13 is a plan view of a portion of a display apparatus according to an embodiment. FIG. 14 is a schematic cross-sectional view of a portion of the display apparatus of FIG. 13, taken along a line II-II' of FIG. 13. In FIG. 14, elements that are the same as those in FIG. 9 are designated by the same reference numerals.

FIG. 13 shows an example of the unit pixel UP applicable to a display apparatus of the disclosure. Referring to FIG. 13, the unit pixel UP may include the first sub-pixel PX1, the second sub-pixel PX2, and the third sub-pixel PX3 that implement different colors from one another. The first sub-pixel PX1, the second sub-pixel PX2, and the third sub-pixel PX3 may be red, green and blue pixels, respectively.

The first sub-pixel PX1 may be implemented by the first light-emitting element LED1, the second sub-pixel PX2 may be implemented by the second light-emitting element LED2, and the third sub-pixel PX3 may be implemented by the third light-emitting element LED3. The first light-emitting element LED1, the second light-emitting element LED2, and the third light-emitting element LED3 may be the inorganic light-emitting diodes 230 and 230' of FIG. 7B or 7C.

In the present embodiment, an area of the first sub-pixel PX1 may be different from an area of the second sub-pixel PX2 and/or an area of the third sub-pixel PX3. For example, the area of the first sub-pixel PX1 may be greater than the area of the second sub-pixel PX2 and/or the area of the third sub-pixel PX3. In some embodiments, an area of the first sub-pixel PX1 may be about 4 times to about 9 times greater an area of the second sub-pixel PX2 and/or an area of the third sub-pixel PX3.

An area or size of the first to third sub-pixels PX1 to PX3 may be determined by the luminous efficiency of the first to third light-emitting elements LED1 to LED3. For example, when the luminous efficiency of the first light-emitting element LED1 emitting red light is less than the luminous efficiency of the second light-emitting element LED2 emitting green light, the first light-emitting element LED1 having a light-emitting area greater than that of the second light-emitting element LED2 may be arranged.

As shown in FIG. 13, the area of the second sub-pixel PX2 may be the same as the area of the third sub-pixel PX3. However, one or more embodiments are not limited thereto. Various modifications may be made, for example, the area of the second sub-pixel PX2 may be different from the area of the third sub-pixel PX3.

The first sub-pixel PX1, the second sub-pixel PX2, and the third sub-pixel PX3 may be arranged at the vertices of a virtual triangle. The contact hole CNT connecting second electrodes of light-emitting elements LED to the common electrode pad CP may be arranged at one side of the second sub-pixel PX2.

Referring to FIG. 14, in the display apparatus according to the present embodiment, the light-emitting elements LED may be disposed above the substrate 100, and protruding electrodes PE connected to the light-emitting elements LED may be disposed between the substrate 100 and the light-emitting elements LED.

The circuit layer 201 may be disposed between the substrate 100 and the light-emitting elements LED, and the circuit layer 201 may include the buffer layer 111, the bottom insulating layer IL, and the pixel driving circuit portion PC. The pixel driving circuit portion PC is electrically connected to the light-emitting element LED.

The first electrode pad EP1, the second electrode pad EP2, the third electrode pad EP3, and the common electrode pad CP may be disposed on the bottom insulating layer IL.

The protruding electrodes PE may be connected to the first electrode pad EP1, the second electrode pad EP2, and the third electrode pad EP3. Each of the protruding electrodes PE may include the protrusion SP and the bonding pad BP disposed on the protrusion SP. The protrusion SP may include an organic insulating material. The protrusion SP may include the via hole VH, and the bonding pad BP may be inserted in the via hole VH. The bonding pad BP may be connected to the first to third electrode pads EP1 to EP3 disposed under the protruding electrode PE through the via hole VH.

The protruding electrodes PE may include the first protruding electrode PE1, the second protruding electrode PE2, and the third protruding electrode PE3.

The first electrode pad EP1 may be disposed under the first protruding electrode PE1, the first light-emitting element LED1 may be disposed on the first protruding electrode PE1, and the first electrode pad EP1 and the first light-emitting element LED1 may be electrically connected to each other by the first protruding electrode PE1.

In the same way, the second electrode pad EP2 and the second light-emitting element LED2 may be electrically connected to each other by the second protruding electrode PE2. The third electrode pad EP3 and the third light-emitting element LED3 may be electrically connected to each other by the third protruding electrode PE3.

In the present embodiment, the thickness t1 of the first protruding electrode PE1 may be different from the thickness t2 of the second protruding electrode PE2 and the thickness t3 of the third protruding electrode PE3, and the thickness t2 of the second protruding electrode PE2 and the thickness t3 of the third protruding electrode PE3 may be the same as each other.

For example, the thickness t1 of the first protruding electrode PE1 may be greater than the thickness t2 of the second protruding electrode PE2 and the thickness t3 of the third protruding electrode PE3. The thickness t1 of the first protruding electrode PE1 may be about 10 µm to about 12 µm. The thickness t2 of the second protruding electrode PE2 and the thickness t3 of the third protruding electrode PE3 may be about 5 µm to about 7 µm.

In this case, the second light-emitting element LED2 and the third light-emitting element LED3 may be epitaxially grown on the same wafer and then transferred to the second protruding electrode PE2 and the third protruding electrode PE3, respectively, during the same transfer process. Next, the first light-emitting element LED1 may be transferred to the first protruding electrode PE1. A size of the first light-emitting element LED1 may be greater than a size of each of the second light-emitting element LED2 and the third light-emitting element LED3.

The top insulating layer IL' at least partially covering the first light-emitting element LED1, the second light-emitting element LED2, and the third light-emitting element LED3 is provided above the substrate 100, and the common electrode 250 is provided on the top insulating layer IL'. The common electrode 250 may be connected to the second electrodes of the first light-emitting element LED1, the second light-emitting element LED2, and the third light-emitting element LED3, and may be connected to the common electrode pad CP through the contact hole CNT.

A display apparatus according to the present embodiments may include protruding electrodes, at least some of which have different thicknesses, thereby improving arrangement precision of light-emitting elements and reducing process time and cost.

The display apparatus 1 according to the previous embodiments may be used in various electronic devices capable of providing an image. In this regard, an electronic device refers to a device that uses electricity and may provide a certain image.

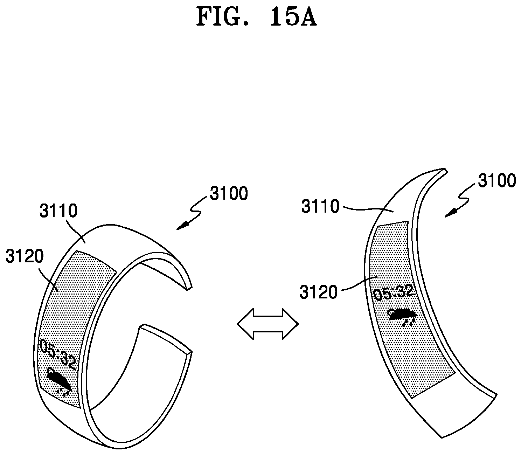

FIGS. 15A to 15G are each a perspective view schematically showing embodiments of an electronic device including a display apparatus according to an embodiment.

Referring to FIG. 15A, a display apparatus according to an embodiment may be used in a wearable electronic device 3100 that may be worn on part of the user's body. The wearable electronic device 3100 may include a body 3110 and a display 3120 on the body 3110. A display apparatus according to one or more embodiments may be used as the display 3120 of the wearable electronic device 3100. As shown in FIG. 15A, a shape of the wearable electronic device 3100 may change. In an embodiment, depending on the user's choice, the wearable electronic device 3100 may be used as a smartwatch or a smartphone.

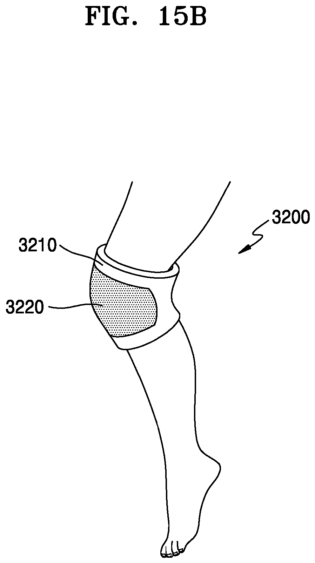

FIG. 15B shows a medical electronic device 3200. In an embodiment, the medical electronic device 3200 may include a body 3210 and a light-emitting portion 3220. A display apparatus according to one or more embodiments may be used as the light-emitting portion 3220 of the medical electronic device 3200. The light-emitting portion 3220 may emit light in a certain wavelength band (e.g., infrared light, visible light, etc.) to the patient's body. In an embodiment, the body 3210 may include a stretchable fiber material and may have a structure that may be worn on the user's body.

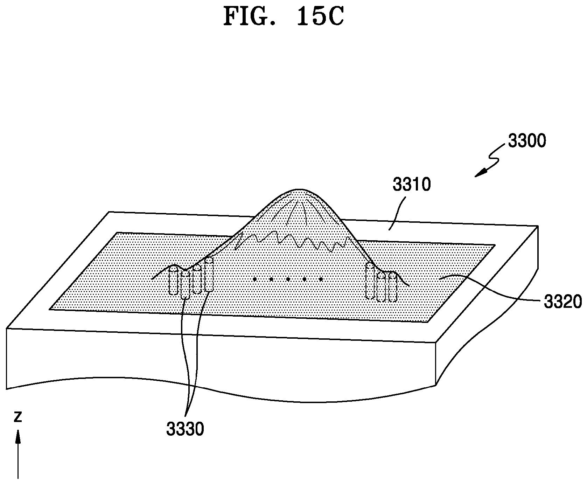

FIG. 15C shows an educational electronic device 3300. In an embodiment, the educational electronic device 3300 may include a display 3320 provided within a frame 3310. The display 3320 may include a display apparatus according to one or more embodiments. An image such as a sea with waves, a mountain covered in snow, or a volcano with flowing lava may be provided through the display 3320, and in this regard, the display 3320 may be stretched in a height direction (e.g., the direction z) to reflect the height of waves, a mountain, or a volcano. In some embodiments, the height of a portion of the display 3320 may be sequentially changed along a direction in which lava flows to three-dimensionally show the movement of lava. The educational electronic device 3300 may include a plurality of pins 3330 (or strokes) disposed on the back of the display 3320 to allow the display 3320 to stretch in the height direction. As the pins 3330 move in a third direction (e.g., the direction z or the direction -z), an image displayed on the display 3320 may be implemented to have a three-dimensional height. Although FIG. 15C illustrates the educational electronic device 3300, its use is not limited as long as it provides certain image information.

Although FIGS. 15A to 15C illustrate an electronic device whose shape may change, one or more embodiments are not limited thereto. As in the following embodiments, a display apparatus according to one or more embodiments may be used in an electronic device in which a portion (e.g., a screen) capable of displaying an image is fixed.

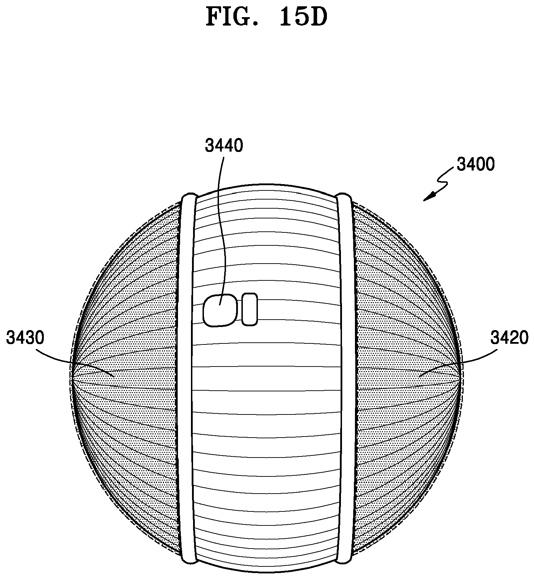

FIG. 15D shows a robot 3400 as an electronic device according to an embodiment. The robot 3400 may recognize a movement or object by using a camera 3440 and may display a certain image to the user through displays 3420 and 3430. In some embodiments, display apparatuses according to an embodiment may be stretched in various directions as described above and thus may be assembled on a body frame having a hemispherical shape, and accordingly, the robot 3400 may include the displays 3420 and 3430 having a hemispherical shape.

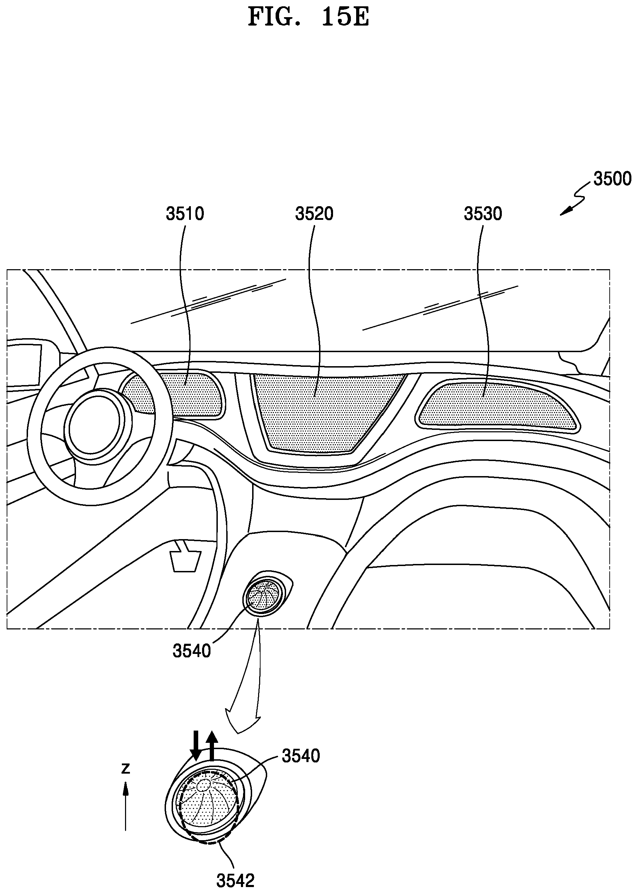

FIG. 15E shows an automotive display device 3500 as an electronic device according to an embodiment. The automotive display device 3500 may include a cluster 3510, a center information display (CID) 3520 and/or a co-driver display 3530. A display apparatus according to one or more embodiments may be stretched in various directions and thus may be used in the cluster 3510, the CID 3520 and/or the co-driver display 3530 regardless of a shape of an inner frame of an automobile.

Although FIG. 15E shows the cluster 3510, the CID 3520 and/or the co-driver display 3530 which are separated individually, one or more embodiments are not limited thereto. In another embodiment, two or more selected from among the cluster 3510, the CID 3520, and the co-driver display 3530 may be integrally connected to each other.

In some embodiments, the automotive display device 3500 may include a button 3540 capable of displaying a certain image. Referring to an enlarged view of FIG. 15E, the button 3540 having a hemispherical shape may include an object 3542 that provides a feeling of using the button while moving in the direction z or the direction -z, and a display apparatus disposed on the object 3542. In some embodiments, when the object 3542 has a three-dimensionally round surface, the display apparatus may also have a three-dimensionally round surface.

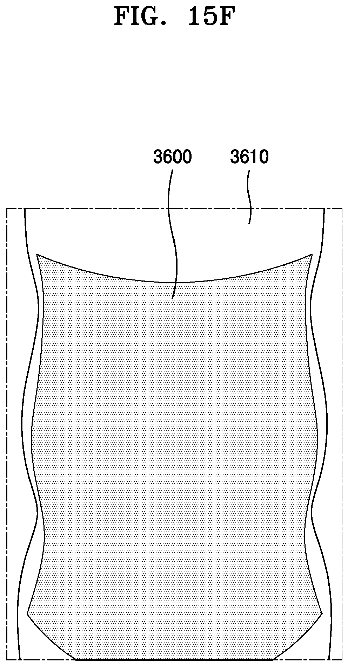

FIG. 15F shows that an electronic device according to an embodiment is an advertising or exhibition electronic device 3600. In some embodiments, the advertising or exhibition electronic device 3600 may be installed on a fixed structure 3610 such as a wall or pillar. When the structure 3610 includes an uneven surface as shown in FIG. 15F, the advertising or exhibition electronic device 3600 may also be disposed along the uneven surface of the structure 3610. In some embodiments, the advertising or exhibition electronic device 3600 may be installed on the structure 3610 by using a heat-shrink film or the like.

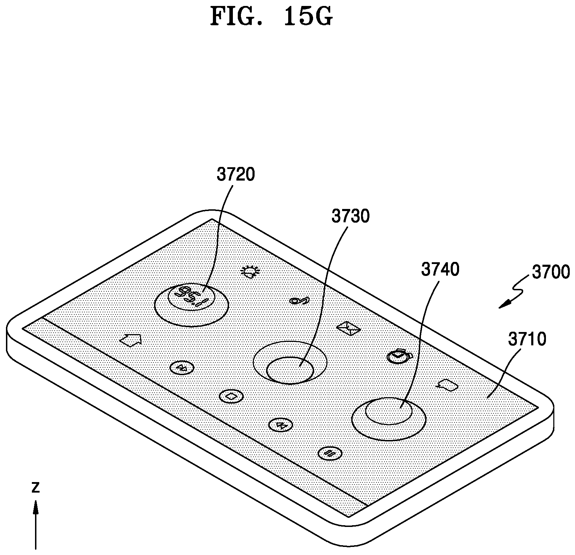

FIG. 15G shows that an electronic device according to an embodiment is a controller 3700. The controller 3700 may include image-type buttons. For example, the controller 3700 may include first to third button areas 3720, 3730, and 3740 in which a partial region of a display 3710 protrudes in the direction z or protrudes in the direction - z (or is depressed in the direction z). In some embodiments, the first and third button areas 3720 and 3740 may protrude in the direction z, and the second button area 3730 may protrude in the direction -z (or be depressed in the direction z).

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. A display apparatus comprising:
a substrate comprising a plurality of island portions apart from each other, a bridge portion connecting the plurality of island portions to each other, and an opening portion arranged between the plurality of island portions; light-emitting elements arranged in each of the plurality of island portions; and
protruding electrodes arranged between the substrate and the light-emitting elements and connected to the light-emitting elements,
wherein the protruding electrodes comprise a first protruding electrode and a second protruding electrode,
wherein a thickness of the first protruding electrode is different from a thickness of the second protruding electrode.

2. The display apparatus of claim 1, wherein the protruding electrodes are apart from each other.

3. The display apparatus of claim 1, wherein the light-emitting elements comprise a first light-emitting element and a second light-emitting element configured to emit lights of different colors from each other,
wherein the first light-emitting element is arranged on the first protruding electrode, and the second light-emitting element is arranged on the second protruding electrode.

4. The display apparatus of claim 1, further comprising:
a circuit layer arranged between the substrate and the protruding electrodes and comprising a pixel driving circuit portion and a bottom insulating layer covering the pixel driving circuit portion;
a common electrode pad and electrode pads arranged on the bottom insulating layer;
a top insulating layer at least partially covering the light-emitting elements and comprising a contact hole exposing the common electrode pad; and a common electrode arranged on the top insulating layer,
wherein each of the light-emitting elements comprises a first electrode arranged at the bottom and a second electrode arranged at the top, wherein second electrodes of the light-emitting elements are electrically connected to the common electrode pad through the contact hole.

5. The display apparatus of claim 1, wherein each of the protruding electrodes comprises:
a protrusion comprising an organic insulating material and comprising a via hole in the middle; and
a bonding pad arranged inside the via hole and on the protrusion and comprising a conductive material.

6. The display apparatus of claim 5, wherein the thickness of the second protruding electrode is greater than the thickness of the first protruding electrode,
wherein the protrusion of the second protruding electrode covers at least a portion of the protrusion of the first protruding electrode.

7. The display apparatus of claim 5, wherein the protrusion of the protruding electrodes protrudes from a lower portion of the light-emitting element, and the bonding pad is arranged under the protrusion.

8. The display apparatus of claim 1, wherein the light-emitting elements comprise a first light-emitting element, a second light-emitting element, and a third light-emitting element emitting light of different colors from one another,
wherein a size of the first light-emitting element is greater than a size of each of the second light-emitting element and the third light-emitting element.

9. The display apparatus of claim 8, wherein the protruding electrodes further comprise a third protruding electrode,
wherein the first light-emitting element, the second light-emitting element, and the third light-emitting element are connected to the first protruding electrode, the second protruding electrode, and the third protruding electrode, respectively,
wherein the thickness of the first protruding electrode is greater than the thickness of the second protruding electrode and a thickness of the third protruding electrode.

10. The display apparatus of claim 9, wherein the thickness of the second protruding electrode is same as the thickness of the third protruding electrode.

11. A display apparatus comprising:
a substrate comprising a plurality of island portions apart from each other, a bridge portion connecting the plurality of island portions to each other, and an opening portion arranged between the plurality of island portions;
a circuit layer comprising a pixel driving circuit portion arranged on the plurality of island portions and a bottom insulating layer covering the pixel driving circuit portion;
a first electrode pad, a second electrode pad, and a third electrode pad arranged on the bottom insulating layer;
a first protruding electrode, a second protruding electrode, and a third protruding electrode arranged on the bottom insulating layer and corresponding to the first electrode pad, the second electrode pad, and the third electrode pad, respectively; and
a first light-emitting element, a second light-emitting element, and a third light-emitting element connected to the first protruding electrode, the second protruding electrode, and the third protruding electrode, respectively,
wherein thicknesses of the first protruding electrode, the second protruding electrode, and the third protruding electrode are different from one another.

12. The display apparatus of claim 11, wherein the first protruding electrode, the second protruding electrode, and the third protruding electrode are apart from one another.

13. The display apparatus of claim 11, wherein the first light-emitting element, the second light-emitting element, and the third light-emitting element are configured to emit lights of different colors from one another.

14. The display apparatus of claim 11, further comprising:
a common electrode pad arranged on the bottom insulating layer at the island portion;
a top insulating layer at least partially covering the first light-emitting element, the second light-emitting element, and the third light-emitting element, and comprising a contact hole exposing the common electrode pad; and
a common electrode arranged on the top insulating layer,
wherein the common electrode is connected to the common electrode pad through the contact hole.

15. The display apparatus of claim 11, wherein each of the first protruding electrode, the second protruding electrode, and the third protruding electrode comprises:
a protrusion comprising an organic insulating material and comprising a via hole in the middle; and
a bonding pad arranged inside the via hole and on the protrusion and comprising a conductive material.

16. The display apparatus of claim 15, wherein protrusions of the first protruding electrode, the second protruding electrode, and the third protruding electrode directly cover the first electrode pad, the second electrode pad, and the third electrode pad, respectively.

17. The display apparatus of claim 15, wherein the thickness of the second protruding electrode is greater than the thickness of the first protruding electrode,
wherein the protrusion of the second protruding electrode covers at least a portion of the protrusion of the first protruding electrode.

18. The display apparatus of claim 11, wherein a size of the first light-emitting element is greater than a size of each of the second light-emitting element and the third light-emitting element.

19. The display apparatus of claim 18, wherein the thickness of the first protruding electrode is greater than the thickness of the second protruding electrode and the thickness of the third protruding electrode.

20. The display apparatus of claim 19, wherein the thickness of the second protruding electrode is same as the thickness of the third protruding electrode.
